# EUROPEAN PATENT APPLICATION

(11) **EP 4 242 686 A1**
(43) Date of publication of application: **13.09.2023**
(21) Application number: 21888943.4
(22) Date of filing: 28.09.2021
(51) Int. Cl.: G01S 7/484, G01S 17/931, H01S 5/02325, H01S 5/0239, H01S 5/183

(54) **SEMICONDUCTOR LASER DRIVING DEVICE, LIDAR PROVIDED WITH SEMICONDUCTOR LASER DRIVING DEVICE, AND VEHICLE PROVIDED WITH SEMICONDUCTOR LASER DRIVING DEVICE**

(30) Priority: 06.11.2020 JP 2020186202
(71) Applicant: Sony Semiconductor Solutions Corporation, Atsugi-shi, Kanagawa 243-0014 (JP)
(72) Inventor: YASUKAWA Hirohisa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/035652
(87) International publication number: WO 2022/097390

(57) **Abstract**

Provided is a semiconductor laser driving apparatus of a division emission scheme which reduces a delay of a light emission pulse due to an influence of a wiring length of a light-emitting element of a VCSEL located far from an LDD, and a vehicle control system including the semiconductor laser driving apparatus.

The configuration includes a vertical cavity surface semiconductor laser (10) having a plurality of light-emitting elements (13), and at least two or more laser diode drivers (20) disposed around the vertical cavity surface semiconductor laser (10) and having a plurality of driving elements that is connected to the light-emitting elements (13) from a peripheral surface of the vertical cavity surface semiconductor laser (10) and causes the light-emitting elements (13) to emit light.

## Description

### TECHNICAL FIELD

The present disclosure relates to a semiconductor laser driving apparatus of a division emission scheme which can be used for light detection and ranging (LIDAR) in which an object is irradiated with a laser in a pulse form from a light source, and scattered light and reflected light of the laser are measured to calculate a distance to the object, a shape of the object, and the like, relates to a LIDAR including the semiconductor laser driving apparatus, and relates to a vehicle including the semiconductor laser driving apparatus.

### BACKGROUND ART

In recent years, automobile manufacturers have conducted research and demonstration experiments to achieve automated driving. In advanced driver-assistance systems (ADAS) such as automatic braking and lane keeping assistance at present, a millimeter-wave radar or a camera is mainly used for detecting a target. However, a millimeter-wave radar and a camera can measure a distance to a target, but are not sufficient to detect an accurate shape and positional relationship. Therefore, attention has been focused on a LIDAR technology capable of three-dimensionally grasping distances, shapes, and positional relationships of preceding vehicles, pedestrians, buildings, and the like.

The principle of the LIDAR is to irradiate an object with a laser light, measure time until the laser light hits the object and returns, and measure a distance and a direction to the object. In this respect, the LIDAR is similar to a radar, but is different in that the radar detects and measures with radio waves, whereas the LIDAR measures with laser light having a wavelength shorter than a wavelength of the radar. Since the measurement is performed with such a short wavelength, the position, the shape, and the like can be detected with high accuracy, and the shape and the positional relationship can be grasped three-dimensionally.

One of measurement schemes of the LIDAR is a time of flight (ToF) scheme. As the name indicates, ToF is a scheme of measuring a "flight time" of light. That is, a pulse of laser light is emitted, and the distance is measured from delay time of emitted light and reflected light.

The LIDAR itself, capable of high-accuracy detection, is a technique that has been conventionally used for observation of terrain and weather. However, since the LIDAR has been used in such a specific special field, being significantly expensive at present is an obstacle for the LIDAR to be widely used for automated driving of automobiles. Therefore, research and development of LIDAR that can be used for automated driving at low cost have been advanced.

Patent Document 1 discloses a ranging sensor of the ToF scheme that operates in cooperation with a camera module, measures time during which a beam radiated to a space is reflected by a target and returned, and generates distance information of the target for generating three-dimensional positional information by combining the distance information with image information acquired by the camera module.

The ranging sensor includes a plurality of light-receiving elements arranged in plane and a light-emitting unit that includes a plurality of light-emitting elements arranged in plane and radiates, toward subspaces obtained by dividing the space, light from the light-emitting elements allocated to every subspace, the light being formed into a beam by a light-emitting lens system. Then, the ranging sensor includes at least a light-receiving unit that receives, by the light receiving lens system, reflected light beams from the subspaces and forms images of the reflected light beams on the light-receiving elements allocated to the subspaces, and a space controller that independently controls every element group that includes the light-emitting element and the light-receiving element that are allocated to a common one of the subspaces.

With the above configuration, an object of the ranging sensor is to provide a ranging sensor of a ToF scheme that operates in cooperation with an RGB camera module mounted on a mobile device and achieves reduction in all of power consumption, a size, and costs.

### CITATION LIST

### PATENT DOCUMENT

Patent Document 1: Japanese Patent Application Laid-Open No. 2019-60652

### SUMMARY OF THE INVENTION

### PROBLEMS TO BE SOLVED BY THE INVENTION

However, in the technology disclosed in Patent Document 1, a light-emitting element of a vertical cavity surface emitting laser (VCSEL) (hereinafter, also referred to as "VCSEL") and a light-emitting element driving unit which is a laser diode driver (hereinafter, also referred to as "LDD") that controls light emission of the light-emitting element are mounted separately in a ToF ranging sensor, and the LDD and the VCSEL are wired and connected by a signal line of a drive signal.

In this case, since the LDD and the VCSEL are separately disposed as separate units, a wiring length between the LDD and the VCSEL inevitably becomes long. In addition, the light-emitting element of the VCSEL located far from the LDD may cause a delay in a light emission pulse due to an influence of wiring impedance and wiring inductance. Furthermore, even if it is attempted to control the VCSEL by a division emission scheme, a problem similarly occurs particularly in a ToF system that controls light emission of the VCSEL at several hundred MHz and LIDAR using the ToF system.

The present disclosure has been made in view of the above problems, and provides a semiconductor laser driving apparatus of a division emission scheme which reduces a wiring length between an LDD and a VCSEL, reduces a delay of a light emission pulse due to an influence of a wiring length of a light-emitting element of the VCSEL located far from the LDD, and reduces an influence of impedance and inductance, a LIDAR including the semiconductor laser driving apparatus, and a vehicle including the semiconductor laser driving apparatus.

### SOLUTIONS TO PROBLEMS

The present disclosure has been made to solve the above problems, and a first aspect of the present disclosure is a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light.

In addition, a second aspect of the present disclosure is a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.

In addition, in the second aspect, each of the driving elements of the laser diode driver may be disposed under the plurality of light-emitting elements included in the vertical cavity surface semiconductor laser, and may be directly linked to each of the light-emitting elements to be drivable.

In addition, in the first or second aspect, the laser diode driver may be configured to drive each of the light-emitting elements of the vertical cavity surface semiconductor laser by a charge charged in a capacitor connected to a power supply line in a chargeable manner.

In addition, in the first or second aspect, the vertical cavity surface semiconductor laser has a surface on which a micro lens array (MLA) may be provided.

In addition, in the first or second aspect, the vertical cavity surface semiconductor laser may have a connection electrode including an Au bump, a solder bump, or a Cu pillar bump.

In addition, in the first or second aspect, the laser diode driver may have a circuit surface built in a substrate or a fan out wafer level package (FOWLP) in a state of facing toward a mounting surface of the vertical cavity surface semiconductor laser.

In addition, in the first or second aspect, a heat dissipation member may be built in the substrate or the fan out wafer level package (FOWLP).

Furthermore, in the first or second aspect, the substrate or the fan out wafer level package (FOWLP) may include an external terminal of a land grid array (LGA) or a ball grid array (BGA).

In addition, a third aspect of the present disclosure is a LIDAR including a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light, or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.

In addition, a fourth aspect of the present disclosure is a vehicle including a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light, or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.

The aspects described above can significantly reduce a wiring length of the LDD and the VCSEL. In addition, the light-emitting element of the VCSEL located far from the LDD can reduce a delay of the light emission pulse and a waveform distortion due to an influence of the wiring length. It is therefore possible to provide a semiconductor laser driving apparatus capable of obtaining an excellent light emission pulse when performing division emission control of the VCSEL, a LIDAR including the semiconductor laser driving apparatus, and a vehicle including the semiconductor laser driving apparatus.

### BRIEF DESCRIPTION OF DRAWINGS

Fig. 1 is a diagram illustrating a configuration example of a LIDAR including a semiconductor laser driving apparatus according to the present technology.
Fig. 2 is a diagram illustrating an example of a package structure of the semiconductor laser driving apparatus according to the present technology.
Fig. 3 is a schematic circuit diagram of the package structure of the semiconductor laser driving apparatus illustrated in Fig. 2.
Fig. 4 is a diagram illustrating a basic configuration example of a package structure of a semiconductor laser driving apparatus according to a first embodiment.
Fig. 5 is a diagram illustrating a first modification of the package structure of the semiconductor laser driving apparatus according to the first embodiment.
Fig. 6 is a diagram illustrating a second modification of the package structure of the semiconductor laser driving apparatus according to the first embodiment.
Fig. 7 is a schematic circuit diagram of the package structure of the semiconductor laser driving apparatus according to the first embodiment.
Fig. 8 is a sectional end view along X-X of Fig. 5A.
Fig. 9 is a diagram illustrating a basic configuration example of a package structure of a semiconductor laser driving apparatus according to a second embodiment.
Fig. 10 is a diagram illustrating a first modification of the package structure of the semiconductor laser driving apparatus according to the second embodiment.
Fig. 11 is a diagram illustrating a second modification of the package structure of the semiconductor laser driving apparatus according to the second embodiment.
Fig. 12 is a schematic circuit diagram of the package structure of the semiconductor laser driving apparatus according to the second embodiment.
Fig. 13 is a diagram illustrating a basic configuration example of a package structure of a semiconductor laser driving apparatus according to a third embodiment.
Fig. 14 is a diagram illustrating a modification of the package structure of the semiconductor laser driving apparatus according to the third embodiment.
Fig. 15A is an arrangement diagram of a light-emitting element of the package structure of the semiconductor laser driving apparatus according to the third embodiment.
Fig. 15B is a schematic circuit diagram of the package structure of the semiconductor laser driving apparatus according to the third embodiment.
Fig. 16 is a diagram illustrating a basic configuration example of a package structure of a semiconductor laser driving apparatus according to a fourth embodiment.
Fig. 17 is a diagram illustrating a modification of the package structure of the semiconductor laser driving apparatus according to the fourth embodiment.
Fig. 18 is a schematic actual wiring diagram of the package structure of the semiconductor laser driving apparatus according to the fourth embodiment.
Fig. 19 is a sectional view of a package structure of a semiconductor laser driving apparatus including a heat dissipation member.
Fig. 20 is an external perspective view of the package structure of the semiconductor laser driving apparatus including the heat dissipation member.
Fig. 21 is a block diagram illustrating an example of a schematic configuration of a vehicle control system.
Fig. 22 is an explanatory diagram illustrating an example of installation positions of an outside-vehicle information detector and an imaging unit.

### MODE FOR CARRYING OUT THE INVENTION

Next, modes for carrying out the technology according to the present disclosure (hereinafter referred to as "embodiment") will be described in the following order with reference to the drawings. Note that, in the following drawings, the same or similar parts are denoted by the same or similar reference signs. In addition, since the drawings are schematic, some descriptions are omitted, and dimensional ratios and the like of each part do not necessarily coincide with actual ones. Furthermore, it is needless to say that the drawings include parts having different dimensional relationships and ratios.
1. Basic configuration example of semiconductor laser driving apparatus according to present technology
2. Configuration example of package structure of semiconductor laser driving apparatus according to first embodiment.
3. Configuration example of package structure of semiconductor laser driving apparatus according to second embodiment.
4. Configuration example of package structure of semiconductor laser driving apparatus according to third embodiment.
5. Configuration example of package structure of semiconductor laser driving apparatus according to fourth embodiment.
6. Configuration example of vehicle control system including semiconductor laser driving apparatus according to present technology

### <1. Basic configuration example of semiconductor laser driving apparatus according to present technology>

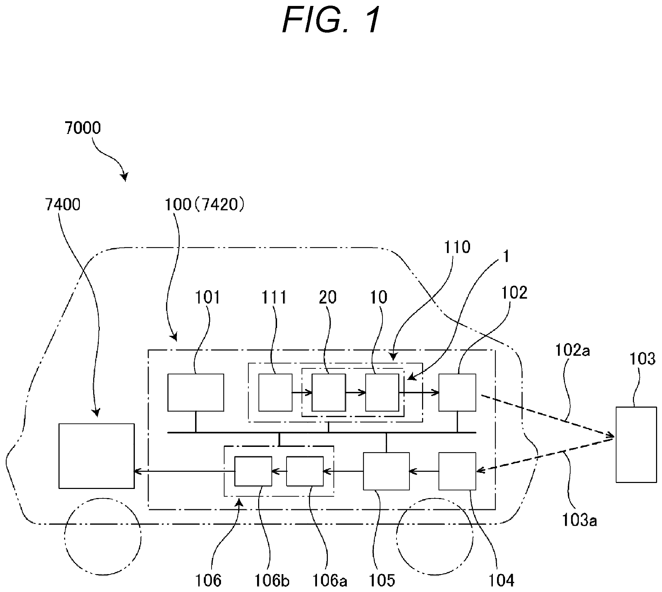

Fig. 1 is a diagram illustrating a configuration example of a LIDAR 100 including a semiconductor laser driving apparatus according to the present technology. In the drawing, a laser generator 110 generates a signal for emitting a laser in a light-emitting element controller 111 and outputs the signal to an LDD 20. The LDD 20 drives a VCSEL 10 by a signal from the light-emitting element controller 111 to emit laser light in a pulse form. A scanning mechanism 102 scans a target 103 existing in front of a vehicle with a laser light 102a.

The scanned laser light 102a is reflected when hitting the target 103 and returns to the LIDAR 100 as a reflected light 103a. The reflected light 103a is received by a light-receiving element 105 via a condenser lens 104. The light-receiving element 105 is, for example, a photosemiconductor element called a silicon photomultiplier (SiPM). The reflected light 103a is converted from an optical signal into an electric signal by the light-receiving element 105.

An output signal of the light-receiving element 105 is input to a measurement circuit 106. The measurement circuit 106 includes an analog-digital conversion circuit (analog to digital converter: hereinafter referred to as "ADC") 106a, a time measurement circuit (time-to-digital converter: hereinafter referred to as "TDC") 106b, and a ranging algorithm. The ADC 106a converts the output signal of the light-receiving element 105, which is an analog signal, into a digital signal. The TDC 106b measures a time difference between the laser light 102a and the reflected light 103a, and measures a distance between the vehicle and the target 103 by the ranging algorithm. That is, a "flight time" of ToF is measured by the measurement circuit 106.

Various data measured by the measurement circuit 106 is passed from the LIDAR 100 to an outside-vehicle information detection unit 7400 which is a configuration unit of a vehicle control system 7000. Note that the outside-vehicle information detection unit 7400, which is a configuration unit of the vehicle control system 7000, will be described later. Furthermore, the LIDAR 100 corresponds to an outside-vehicle information detector 7420 of the vehicle control system 7000.

A microcontroller (microcontroller: hereinafter referred to as "MCU") 101 is a control device that controls the entire LIDAR 100. The MCU 101 is a type of computer used in an embedded system such as an electronic device, and is called a microcomputer. The MCU 101 includes a CPU core, a memory (ROM or flash memory) that stores a program, a timer, an input-output unit that exchanges signals with an external peripheral device or the like, and a communication port. Then, all of the above are incorporated in one integrated circuit. Therefore, using the MCU 101 can reduce a size and a price of the LIDAR 100.

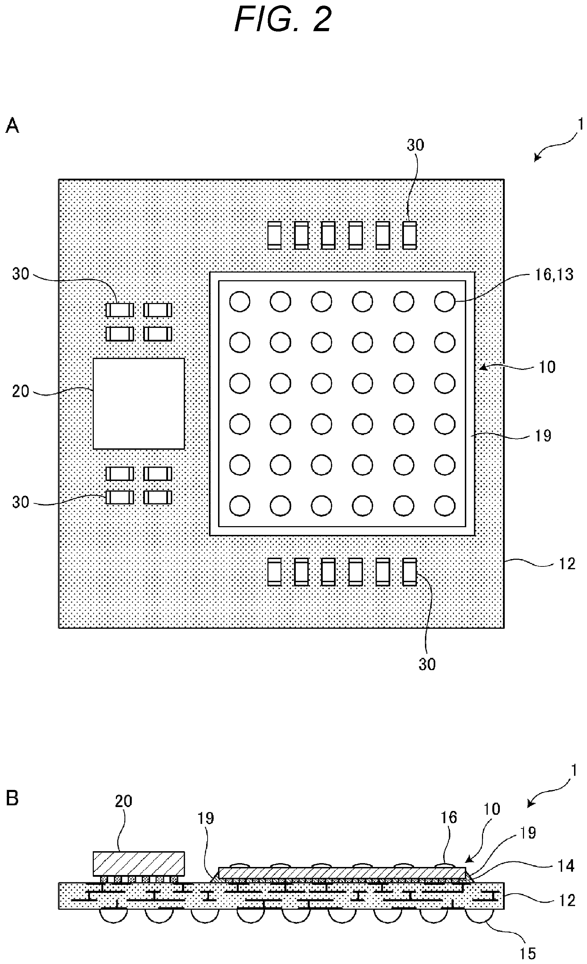

As illustrated in Fig. 2A, the LDD 20 and the VCSEL 10 of a semiconductor laser driving apparatus 1 in Fig. 1 are disposed on one package so as to face each other. Then, a capacitor 30 is disposed around the VCSEL 10. The VCSEL 10 is configured such that light-emitting elements 13 that emit laser light are arranged in a lattice (matrix) on a substrate 12. This drawing illustrates an example in which a total of 36 light-emitting elements 13 including 6 vertical and 6 horizontal light-emitting elements are arranged in a matrix.

In addition, an entire upper surface of each light-emitting element 13 is covered with a semi-insulating substrate (not shown), and a light-emitting surface of the VCSEL 10 has microlenses arranged in a matrix on an upper surface corresponding to the arrangement of each light-emitting element 13. As a whole, a micro lens array (hereinafter referred to as "MLA") 16 is configured. Therefore, a light-emitting area can be increased, and an irradiation direction of the VCSEL 10 can be widened by an action of the lens.

The MLA 16 transmits the laser light emitted from each light-emitting element 13, and scans the target 103 as the laser light 102a via the scanning mechanism 102. Then, a periphery of the VCSEL 10 is sealed by an underfill 19. Note that the underfill 19 is a generic term for liquid curable resins used for sealing an integrated circuit.

As illustrated in the sectional view of Fig. 2B, each light-emitting element 13 disposed immediately under the MLA 16 of the VCSEL 10 is electrically connected to the substrate 12 by a connection electrode 14. For example, the substrate 12 is provided with a wiring layer, and the light-emitting element 13 is electrically connected to the external terminal 15 by the wiring layer.

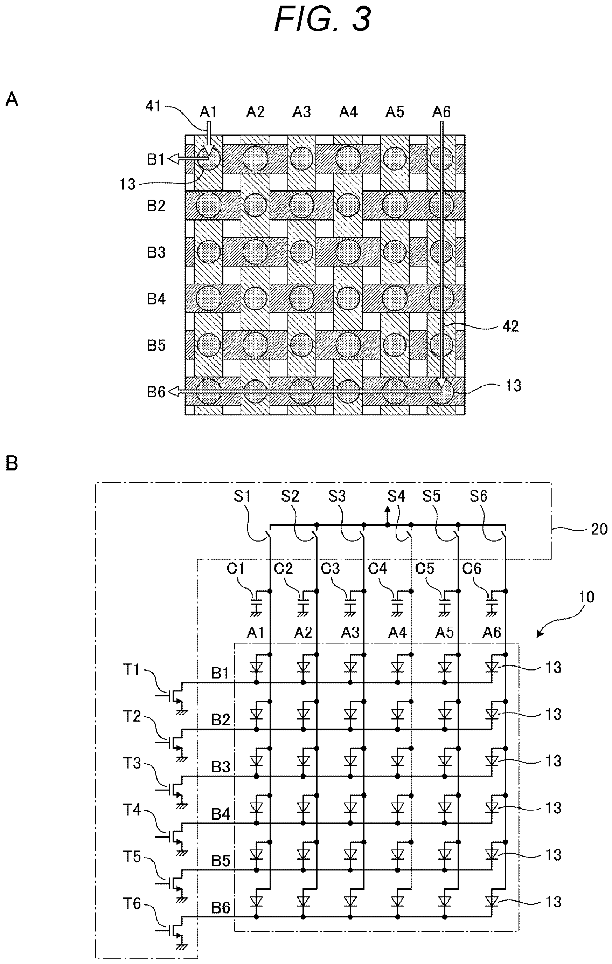

Next, the circuit configuration of the light-emitting element 13 will be described more specifically. The LDD 20 is disposed at a position facing the VCSEL 10. Then, as illustrated in Fig. 3 described later, driving elements T1 to T6 built in the LDD 20 are electrically connected to a negative electrode (cathode) of the light-emitting element 13, and are configured to be energized to the corresponding light-emitting element 13 by on-off operation of the drive elements T1 to T6 to emit laser light.

Positive electrodes of the six light-emitting elements 13 arranged in the vertical direction at coordinates B1 to B6 are electrically connected to each other in parallel as illustrated in Fig. 3B. Similarly, as illustrated in Figs. 3A and 3B, the negative electrodes of the six light-emitting elements 13 of coordinates A1 to A6 arranged in the horizontal direction are electrically connected to each other in parallel.

The positive electrodes of the six light-emitting elements 13 arranged in the vertical direction at the coordinates B1 to B6 are connected to one ends of switches S1 to S6 and positive electrodes of the capacitors C1 to C6, respectively, arranged at the coordinates A1 to A6. Furthermore, negative electrodes of the capacitors C1 to C6 are connected to a ground. However, in a case where nonpolar capacitors are used as the capacitors C1 to C6, polarity of the positive electrode, the negative electrodes, or the like does not matter. In addition, the other ends of the switches S1 to S6 are connected to a power supply circuit.

Here, the switches S1 to S6 are not limited to mechanical switches or a-contacts, but are elements having an opening-closing function of a circuit including an electronic switch such as a transistor or a MOS FET. In addition, each of the capacitors C1 to C6 does not correspond to one physical capacitor 30 but is a function.

Therefore, the capacitors C1 to C6 may include a plurality of capacitors 30, or may exhibit a predetermined function by combining capacitors 30 having different frequency characteristics. In addition, a shape of the capacitors 30 is not limited to a shape illustrated in Fig. 2A, and any shape is included. The following embodiments are configured in a similar manner to the above, and thus detailed description of each embodiment is omitted.

As described above, the negative electrodes of the six light-emitting elements 13 arranged in the horizontal direction are electrically connected to each other in parallel and connected to drains of the driving elements (for example, MOS FETs) T1 to T6 built in the LDD 20. In addition, sources of the driving elements T1 to T6 are connected to the ground.

Next, a sequence of causing the light-emitting element 13 of the VCSEL 10 to emit light will be described with reference to Fig. 3, considering the light-emitting element 13 connected to the coordinates A1, B1 for example. (1) First, the switch S1 is turned on to charge the capacitor C1. (2) Next, the driving element T1 is turned on. (3) Accordingly, current flows through the light-emitting element 13 connected to the coordinates A1, B1 to emit light. (4) The driving element T1 is turned off. As a result, current does not flow through the light-emitting element 13, and light emission stops. In this case, the current takes a path of the coordinate A1, the light-emitting element 13, and the coordinate B1 as indicated by an arrow 41 in Fig. 3A. (5) Note that individual light emission control can be performed by performing (2) to (4) for the desired light-emitting element 13 in a state where (1) is performed.

Note that, since the capacitors C1 to C6 are provided for every drive circuit of the VCSEL 10 in this configuration, light emission of the light-emitting element 13 is performed by either electric charges charged in the capacitors C1 to C6 or current supply from a power supply, or both. The capacitors C1 to C6 can reduce output impedance of the power supply circuit and can instantaneously supply an inrush current necessary for light emission of the light-emitting element 13. In addition, since each light-emitting elements 13 is caused to emit light in order in a time division manner, charging can be done after discharge before the next discharge. As a result, a rise/fall time of a drive waveform of the VCSEL 10 is reduced, and a waveform distortion can be improved. In addition, noise entering a power supply system from outside and spike noise generated when the circuit operates at high speed can be absorbed. Therefore, the waveform can be improved, and malfunction can be prevented.

Next, the light-emitting element 13 connected to the coordinates A6, B6 will be described as an example. (1) First, the switch S6 is turned on to charge the capacitor C6. (2) Next, the driving element T6 is turned on. (3) Accordingly, current flows through the light-emitting element 13 connected to the coordinates A6, B6 to emit light. (4) The driving element T6 is turned off. As a result, current does not flow through the light-emitting element 13, and light emission stops. In this case, the current takes a path of the coordinate A6, the light-emitting element 13, and the coordinate B6 as indicated by an arrow 42 in Fig. 3A.

As described above, in a basic configuration example of the semiconductor laser driving apparatus according to the present technology, the LDD 20 and the VCSEL 10 are disposed on one package so as to face each other. As a result, a wiring length of the LDD 20 and the VCSEL 10 can be significantly reduced. In addition, the current flows in the path indicated by the arrow 41 in the light-emitting element 13 connected to the coordinates A1, B1, whereas the current flows in the path indicated by the arrow 42 in the light-emitting element 13 connected to the coordinates A6, B6. That is, a ratio of the shortest path to the longest path for flowing current is 2:12. In addition, the difference in wiring length is 12 - 2 = 10. Such a difference in wiring length brings about a signal propagation delay, and thus causes an error in ToF. It is therefore desirable not to cause a difference in wiring length.

In addition, since the wiring of the light-emitting element 13 connected to the coordinates A6, B6 has a long wiring length and easily forms a current loop, wiring inductance from a power supply terminal to the LDD 20 increases, and there is a possibility that the drive waveform of the VCSEL 10 is distorted. Such waveform distortion is particularly problematic in ToF driven at several hundred megahertz or the LIDAR 100 using the ToF. Therefore, on the basis of this basic configuration example, an embodiment for further reducing the wiring length and the difference in wiring length between the LDD 20 and the light-emitting element 13 disposed in the VCSEL 10 will be described below.

### <2. Configuration example of package structure of semiconductor laser driving apparatus according to first embodiment>

### [Basic configuration example of first embodiment]

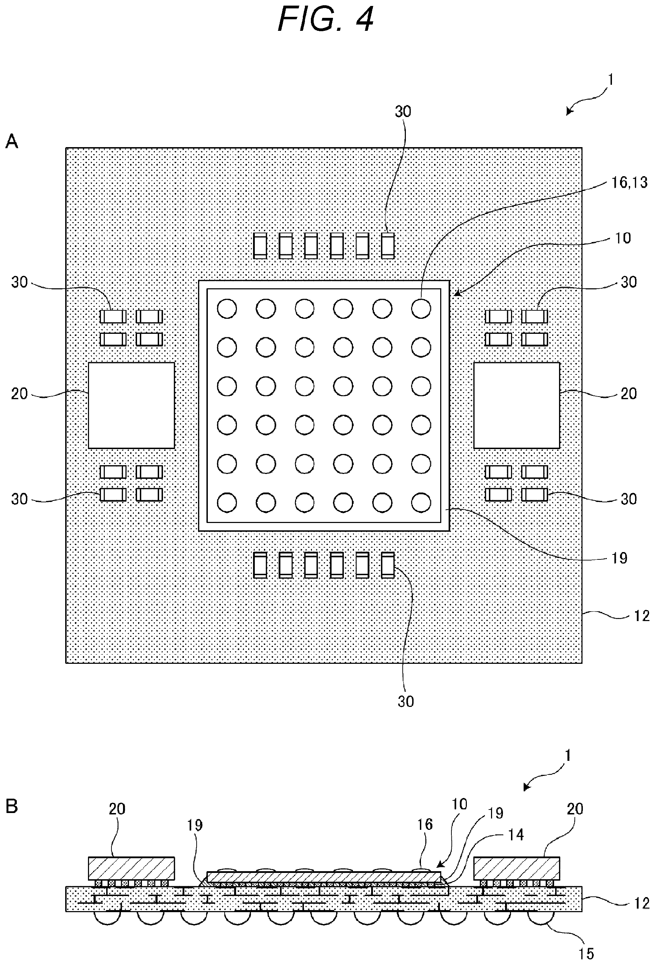

Fig. 4 is a diagram illustrating a basic configuration example of a package structure of a semiconductor laser driving apparatus according to a first embodiment. As illustrated in Figs. 4A and 4B, the VCSEL 10 of the semiconductor laser driving apparatus 1 is disposed substantially in a center on the package. Two LDDs 20 are disposed to face each other across the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 4 in the present embodiment is different from the configuration of Fig. 2 described above in terms of the two LDDs 20 and the circuit configuration. Other configurations are the same as those in Fig. 2. Therefore, description of the sectional view of Fig. 4B is omitted.

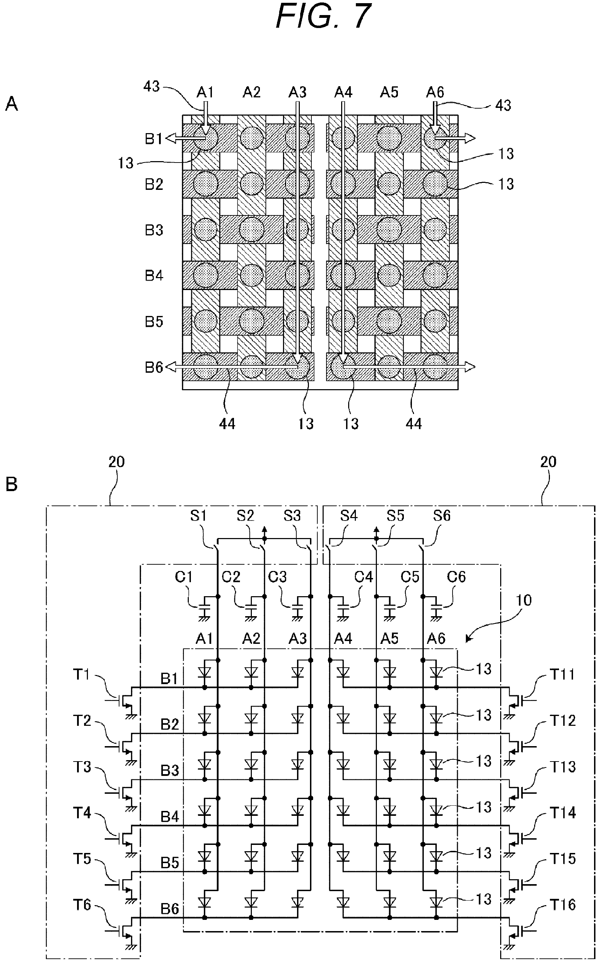

Next, the circuit configuration of the light-emitting element 13 will be described specifically. As illustrated in Figs. 7A and 7B, the six light-emitting elements 13 of the coordinates B1 to B6 arranged in the vertical direction of the VCSEL 10 are divided into two groups which are a group of the coordinates A1 to A3 and a group of the coordinates A4 to A6 in the horizontal direction.

Then, the positive electrodes of the six light-emitting elements 13 arranged in the vertical direction and having coordinates B1 to B6 are electrically connected to each other in parallel as illustrated in Fig. 7B. Similarly, the negative electrodes of the three light-emitting elements 13 of the group of the coordinates A1 to A3 arranged in the horizontal direction are electrically connected to each other in parallel. Furthermore, the negative electrodes of the three light-emitting elements 13 of the group of the coordinates A4 to A6 arranged in the horizontal direction are electrically connected to each other in parallel.

The positive electrodes of the six light-emitting elements 13 arranged in the vertical direction at the coordinates B1 to B6 are connected to one ends of the switches S1 to S3 and S4 to S6 arranged at the coordinates A1 to A3 and A4 to A6 and the capacitors C1 to C3 and C4 to C6, respectively, similarly to the case of Fig. 3. Furthermore, the other ends of the switches S1 to S3 and S4 to S6 are connected to the power supply circuit. Here, the switches S1 to S3 and S4 to S6 and the capacitors C1 to C3 and C4 to C6 are similar to those in the case of Fig. 3 described above.

The three light-emitting elements 13 in the group of the coordinates A1 to A3 and the three light-emitting elements 13 in the group of the coordinates A4 to A6 arranged in the horizontal direction have negative electrodes connected to each other in parallel for every group, and are respectively connected to the drains of the driving elements (for example, MOS FETs) T1 to T6 and T11 to T16 built in the LDD 20. In addition, the sources of the driving elements T1 to T6 and T11 to T16 are connected to the ground.

Next, a sequence of causing the light-emitting element 13 of the VCSEL 10 to emit light will be described with reference to Fig. 7, considering the light-emitting element 13 connected to the coordinates A1, B1 for example. (1) First, the switch S1 is turned on to charge the capacitor C1. (2) Next, the driving element T1 is turned on. (3) Accordingly, current flows through the light-emitting element 13 connected to the coordinates A1, B1 to emit light. (4) The driving element T1 is turned off. As a result, current does not flow through the light-emitting element 13, and light emission stops. In this case, the current takes a path of the coordinate A1, the light-emitting element 13, and the coordinate B1 as indicated by an arrow 43 in Fig. 7A. Note that the light-emitting element 13 connected to the coordinates A6, B1 is configured in a similar manner. (5) Note that individual light emission control can be performed by performing (2) to (4) for the desired light-emitting element 13 in a state where (1) is performed.

Next, the light-emitting element 13 connected to the coordinates A3, B6 will be described as an example. (1) First, the switch S3 is turned on to charge the capacitor C3. (2) Next, the driving element T6 is turned on. (3) Accordingly, current flows through the light-emitting element 13 connected to the coordinates A3, B6 to emit light. (4) The driving element T6 is turned off. As a result, current does not flow through the light-emitting element 13, and light emission stops. In this case, the current takes a path of the coordinate A3, the light-emitting element 13, and the coordinate B6 as indicated by an arrow 44 in Fig. 3A. Note that the light-emitting element 13 connected to the coordinates A4, B6 is configured in a similar manner.

Such a configuration makes it possible to divide the 36 light-emitting elements 13 into 18 of each group, sequentially select one by one, and cause the light-emitting elements to emit light in a time division manner. Here, by causing the light-emitting element 13 to perform continuous pulse light emission, the temperature gradually increases, and a current and light emission characteristic (I-L characteristic) decreases. However, as in the present embodiment, by emitting light in a time division manner by short pulse light emission, it is possible to suppress a temperature rise of the light-emitting element 13. In addition, the suppression of the temperature rise leads to improvement of the I-L characteristic, and laser power can be improved, and therefore a farther object can be detected. Furthermore, a total power consumption can be reduced.

As described above, in the basic configuration example of the first embodiment, the current flows in the path passing through one light-emitting element 13 indicated by the arrow 43 in the light-emitting element 13 connected to the coordinates A1, B1, whereas the current flows in the path passing through eight light-emitting elements 13 indicated by the arrow 44 in the light-emitting element 13 connected to the coordinates A3, B6. That is, the ratio of the shortest path to the longest path for flowing current is 2:9. In addition, the difference in wiring length is 9 - 2 = 7. As described above, the wiring length is improved to 9/12 and the difference in wiring length is improved to 7/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

### [First modification of first embodiment]

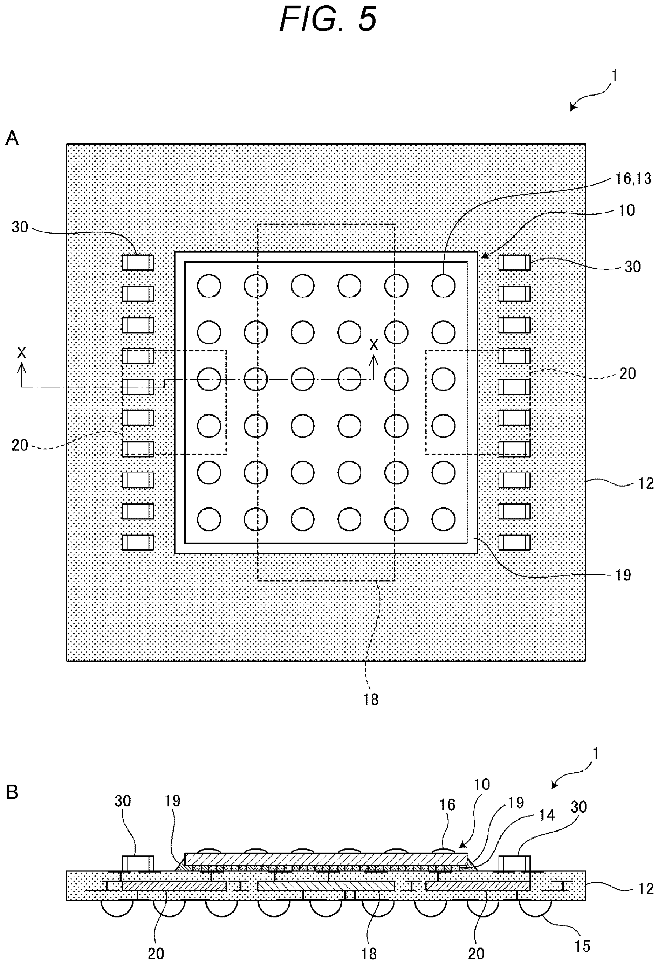

Fig. 5 is a diagram illustrating a first modification of the package structure of the semiconductor laser driving apparatus according to the first embodiment. As illustrated in Figs. 5A and 5B, the VCSEL 10 of the semiconductor laser driving apparatus 1 is disposed substantially in the center on the package. Two LDDs 20 are disposed inside the substrate 12 to face each other across the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 5 in the present embodiment and the configuration of Fig. 4 described above are different in that two LDDs 20 are built in the substrate 12 and a heat dissipation member 18 is provided in the substrate 12. Other configurations are the same as those in Fig. 4. Hereinafter, the structure will be described.

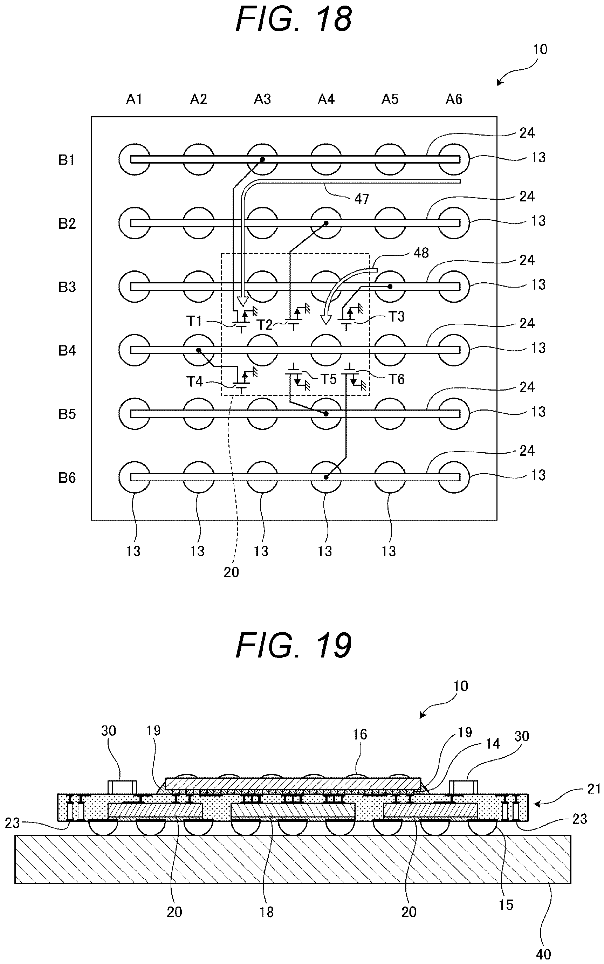

As illustrated in Figs. 5A and 5B, the heat dissipation member 18 is disposed inside the substrate 12 substantially below a center of the VCSEL 10. The heat dissipation member 18 transmits generated heat to the heat dissipation member 18 built in the substrate 12 via substrate wire or a thermal via by energizing the light-emitting element 13 and the LDD 20 for laser emission. The heat dissipation member 18 built in a FOWLP 21 is configured in a similar manner. Then, as illustrated in Fig. 19, the heat transmitted to the heat dissipation member 18 is transmitted from an upper surface to a lower surface of the heat dissipation member 18 having a small thermal resistance, and is transmitted to the external terminal 15 of the package via the substrate wire or the thermal via disposed in close contact with the lower surface. Then, the heat is transmitted to a metal pattern of a motherboard 40 via a metal such as a solder material. As a result, the heat generated in the semiconductor laser driving apparatus 1 can be efficiently released to the motherboard 40, and a temperature rise can be suppressed.

In addition, since the heat dissipation member 18 has a small thermal resistance, by providing the heat dissipation member 18 with a predetermined thickness, a thermal resistance between the VCSEL 10 and the heat dissipation member 18 and a thermal resistance between the heat dissipation member 18 and the external terminal 15 can be reduced. Furthermore, the substrate wiring or the thermal via can be shortened, high thermal conduction can be achieved as a whole. As a result, heat can be efficiently dissipated to the motherboard 40.

In addition, the LDD 20 is configured in a similar manner. The substrate wiring or the thermal via is disposed in close contact with the lower surface of the LDD 20, and the substrate wiring or the thermal via is directly linked to the external terminal 15. Therefore, high thermal conduction is achieved, heat generated by the LDD 20 can be efficiently released to the motherboard 40, and a temperature rise can be suppressed.

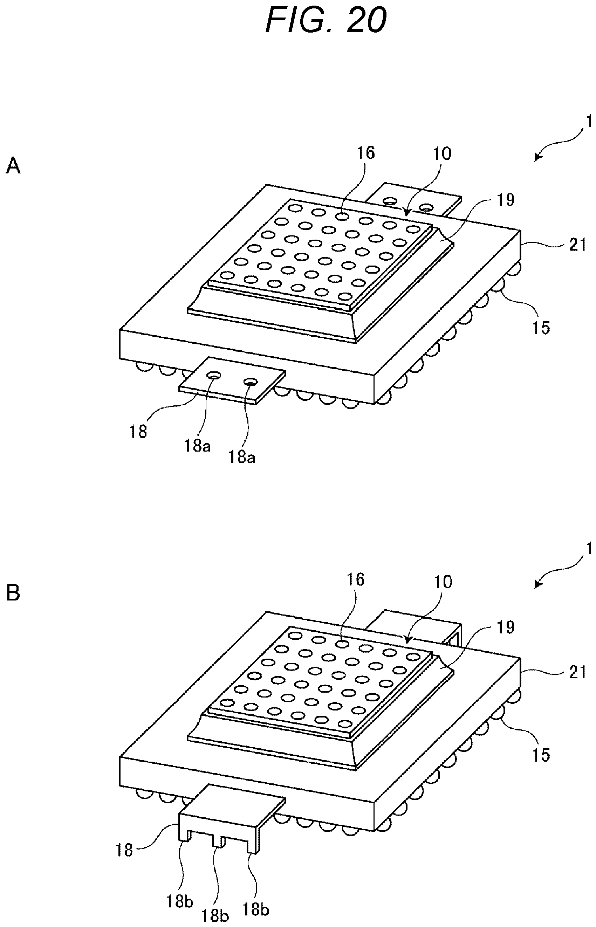

Note that, in Fig. 5A, the heat dissipation member 18 has a substantially rectangular shape, but is not limited to the shape illustrated in Fig. 5A, and desirably has a form as large as possible within an allowable range of layout on the substrate 12. In addition, the heat dissipation member 18 can extend in the vertical direction of this drawing and protrude from the substrate 12. For example, as illustrated in Fig. 20A, the heat dissipation member 18 may protrude from a side surface of the substrate 12 or the FOWLP 21, and an attachment hole 18a may be provided at a distal end of the heat dissipation member 18. The attachment hole 18a may be used to connect to a radiator such as a heat sink having a predetermined thermal resistance. In addition, a lead wire or the like is soldered by using the attachment hole 18a, and the lead wire or the like is soldered to a through hole provided in the metal pattern of the motherboard 40. Then, heat can be released to the motherboard 40. As a result, a temperature rise of the VCSEL 10 can be suppressed.

In addition, as illustrated in Fig. 20B, the heat dissipation member 18 protruding from the side surface of the substrate 12 or the FOWLP 21 may be extended by a predetermined length and bent downward, and a predetermined number of connection protrusions 18b having a substantially rod shape may be provided at the distal end of the heat dissipation member 18. The connection protrusion 18b is used to perform soldering to the through hole (not shown) provided in the metal pattern of the motherboard 40 having a predetermined thermal resistance. Then, heat can be released to the motherboard 40. As a result, a temperature rise of the VCSEL 10 can be suppressed.

Note that the protruding heat dissipation member 18 may be extended by a predetermined length and bent downward, and further bent outward or inward, and the bent surface may be used as a soldering surface with the motherboard 40. In addition, the protrusion of the heat dissipation member 18 may be provided on only one side surface or both side surfaces. Further, the protrusion may be provided on the four side surfaces, if possible. Note that although Fig. 20A illustrates an example in which two attachment holes 18a are provided, the number of attachment holes is not limited to two, and a necessary number of attachment holes may be provided. Other than a round hole, the attachment hole 18a may be an elliptical hole or the like. In addition, although Fig. 20B illustrates an example in which three connection protrusions 18b are provided, the number of connection protrusions is not limited to three, and a necessary number of connection protrusions may be provided. Furthermore, the connection protrusion 18b may have a cross section of round, square, or the like. The length of the connection protrusion 18b is also only required to be determined as necessary. Similarly, the length and width of the protruding heat dissipation member 18 is only required to be determined as necessary. Note that the following embodiments are configured in a similar manner to the above, and thus detailed description of the heat dissipation member 18 in each embodiment is omitted.

Next, in a similar manner to Figs. 7A and 7B, the 36 light-emitting elements 13 of the VCSEL 10 arranged in a matrix are divided into two groups which are the group of the coordinates A1 to A3 and the group of the coordinates A4 to A6. Then, a circuit configuration of each light-emitting element 13 and a sequence of causing the light-emitting element 13 to emit light are similar to those of the basic configuration example of the first embodiment. Therefore, description of the circuit configuration and the sequence is omitted.

As described above, in a similar manner to the basic configuration example of the first embodiment, as for the wiring length for causing current to flow, the ratio of the shortest path to the longest path of the wiring length for causing current to flow is 2:9 in the first modification. In addition, the difference in wiring length is 9 - 2 = 7. As described above, the wiring length is improved to 9/12 and the difference in wiring length is improved to 7/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved. In addition, since the heat dissipation member 18 is disposed inside the substrate 12, a temperature rise accompanying laser light emission can be suppressed. Therefore, the laser power can be further increased, and a farther object can be detected.

### [Second modification of first embodiment]

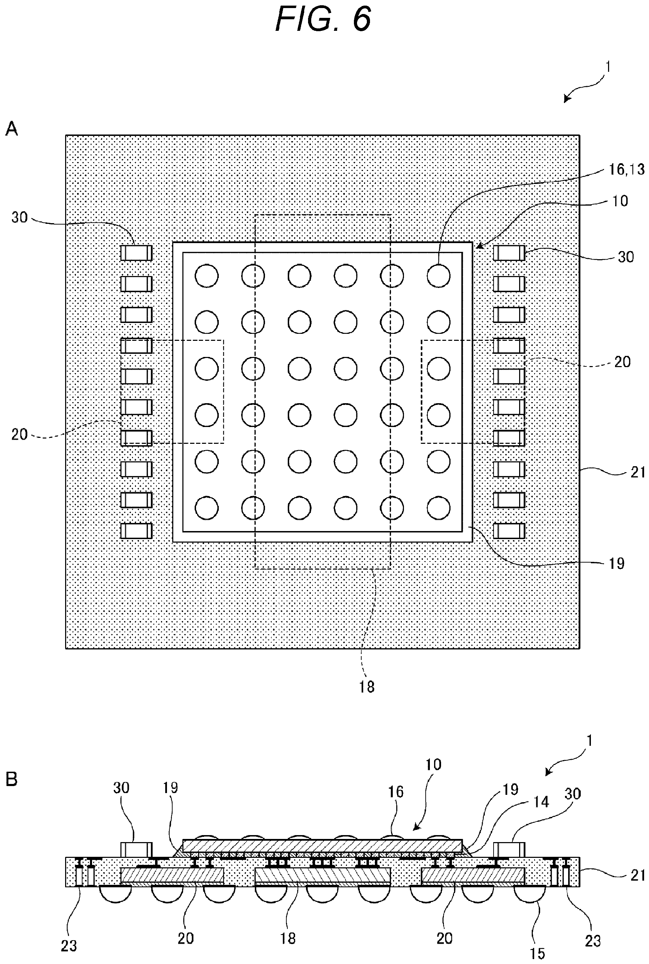

Fig. 6 is a diagram illustrating a second modification of the package structure of the semiconductor laser driving apparatus according to the first embodiment. As illustrated in Figs. 6A and 6B, the VCSEL 10 of the semiconductor laser driving apparatus 1 is disposed substantially in the center on the package. Two LDDs 20 are disposed inside the substrate 12 to face each other across the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, the periphery of the VCSEL 10 is sealed by the underfill 19.

A configuration of Fig. 6 in the present embodiment and the basic configuration example of Fig. 5 described above are different in that the package structure has two LDDs 20 disposed in the FOWLP 21. The other configurations and the circuit configuration of the light-emitting elements 13 are the same as those in the case of Fig. 5. That is, as illustrated in Figs. 7A and 7B, the six light-emitting elements 13 of the coordinates B1 to B6 arranged in the vertical direction of the VCSEL 10 are divided into two groups which are a group of the coordinates A1 to A3 and a group of the coordinates A4 to A6. Then, a circuit configuration of each light-emitting element 13 and a sequence of causing the light-emitting element 13 to emit light are similar to those of the basic configuration example of the first embodiment. Therefore, description of the circuit configuration and the sequence is omitted.

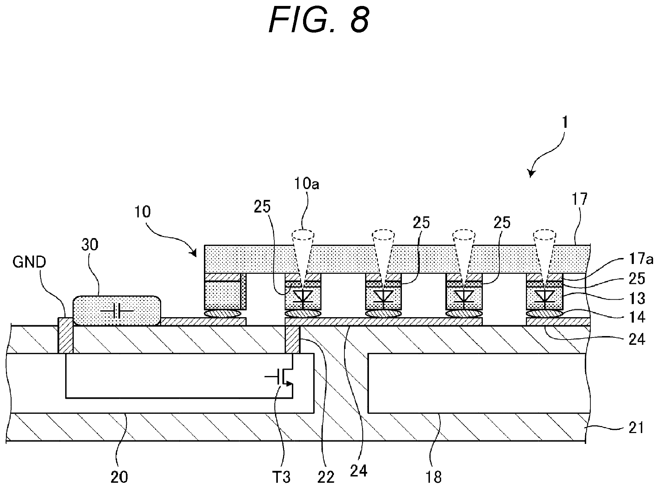

Next, the structure will be described. As illustrated in a sectional end view along X-X of Fig. 6A in Figs. 6B and 8, the semiconductor laser driving apparatus 1 according to the present technology is configured in an aspect in which a mounting surface of the circuit of the VCSEL 10 on which the light-emitting elements 13 are mounted faces a mounting surface of the circuit of the substrate 12 or the FOWLP 21 on which the LDDs 20 that drive the VCSEL 10 are mounted. Such a configuration can reduce the wiring length between the LDDs 20 and the VCSEL 10. As a result, it is possible to suppress a delay of the drive waveform and occurrence of the waveform distortion, and to obtain a favorable light emission pulse.

That is, since the LDDs 20 and the VCSEL 10 are disposed so as to face each other, each light-emitting element 13 of the VCSEL 10 is directly electrically connected to a wiring layer of the substrate 12 or the FOWLP 21, a connection via, or the like via the connection electrode 14. Specifically, the negative electrode (cathode) of each light-emitting element 13 disposed on a back surface (lower surface) of the VCSEL 10 is connected to a metal layer 24 formed on the substrate 12 or an upper surface of the FOWLP 21 via the connection electrode 14. The metal layer 24 electrically connects the negative electrodes of the light-emitting elements 13 in parallel. In addition, a metal layer 25 electrically connects the positive electrodes of the light-emitting elements 13 in parallel.

Furthermore, a signal from a light-emitting element controller 111 that controls the driving elements T1 to T6 and the like of the LDD 20, and a circuit such as a power supply and the ground are electrically connected to the external terminal 15 by a connection via 22 formed in the substrate 12 or the FOWLP 21, a TMV 23 illustrated in Fig. 6B, a metal wiring layer, and the like. As described above, since the semiconductor laser driving apparatus 1 according to the present technology is configured in a mode in which a mounting surface of the light-emitting elements 13 or the like of the VCSEL 10 faces a mounting surface of the LDDs 20 of the substrate 12 or the FOWLP 21, the LDD 20 and the VCSEL 10 can be linked by the shortest wiring by bonding the connection electrode 14.

The connection electrode 14 includes an Au bump, a solder bump, or a Cu pillar bump. Such a configuration can cope with all variations of the connection electrodes 14 of the VCSEL 10. Furthermore, the external terminal 15 is a land grid array (LGA) or a ball grid array (BGA). Such a configuration can cope with all variations of the external terminal 15 of the package. Note that the aspect in which the mounting surface of the light-emitting elements 13 of the VCSEL 10 and the mounting surface of the LDDs 20 face each other and the configuration of the connection electrode 14 are similar to those in the following embodiments, and thus the detailed description thereof in each embodiment is omitted.

Next, connection of the LDDs 20, the capacitor 30, and the light-emitting elements 13 in Fig. 8 will be described. In Fig. 5A, the LDDs 20 are disposed on the left and right sides of the VCSEL 10 so as to face each other. On the basis of such a positional relationship, the coordinates for connecting the VCSEL 10 and the LDDs 20 are the coordinates A1 to A6 from the left to the right and the coordinates B1 to B6 from the top to the bottom in the drawing.

In Fig. 8, the metal layer 25 and a P+ layer 17a are disposed on an upper surface of the positive electrode (anode) of each light-emitting element 13 along the coordinates A1 to A3, B3, that is, in the left-right direction of Fig. 8. The positive electrodes of the three light-emitting elements 13 of the coordinates A1 to A3, B3 are electrically connected by the metal layer 25. Then, the entire upper surface is covered with a semi-insulating substrate 17 forming the MLA 16. In addition, the negative electrode (cathode) of each light-emitting element 13 is electrically connected by the metal layer 24 via the connection electrode 14.

The drains of the driving elements T1 to T6 and T11 to T16 (MOS FETs) of the two LDDs 20 disposed below the VCSEL 10 are connected to the metal layer 24 via the connection vias 22, respectively. On the other hand, the sources of the driving elements T1 to T6 and T11 to T16 (MOS FETs) are connected to the ground (GND). Thus, in the drawing, when the driving element T6 is turned on, current flows through the light-emitting element 13 to emit light, and laser light is emitted. In addition, a positive electrode of the capacitor 30 is connected to the metal layer 25, and a negative electrode of the capacitor 30 is connected to the ground (GND). Note that, in a case where the capacitor 30 is nonpolar, the polarity does not matter.

Furthermore, in the description of this example, the coordinates for connecting the light-emitting elements 13 are the coordinates A1 to A3 and A4 to A6 from the left to the right and the coordinates B1 to B6 from the top to the bottom in the drawing. Alternatively, the coordinates may be the coordinates A1 to A3 and A4 to A6 from the bottom to the top and the coordinates B1 to B6 from the left to the right, and the positive electrode and the negative electrode of each light-emitting element 13 may be arranged to be wired by the metal layers 24 and 25.

As illustrated in Fig. 8, the heat dissipation member 18 is disposed inside the substrate 12 or the FOWLP 21 substantially below the center of the VCSEL 10. Note that the heat dissipation member 18 is similar to those of the first modification of the first embodiment illustrated in Fig. 5.

As described above, in the second modification, in a similar manner to the basic configuration example of the first embodiment, the ratio of the shortest path to the longest path of the wiring length for causing current to flow is 2:9. In addition, the difference in wiring length is 9 - 2 = 7. As described above, the wiring length is improved to 9/12 and the difference in wiring length is improved to 7/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved. In addition, since the heat dissipation member 18 is disposed inside the FOWLP 21, a temperature rise accompanying laser light emission can be suppressed.

### <3. Configuration example of package structure of semiconductor laser driving apparatus according to second embodiment>

### [Basic configuration example of second embodiment]

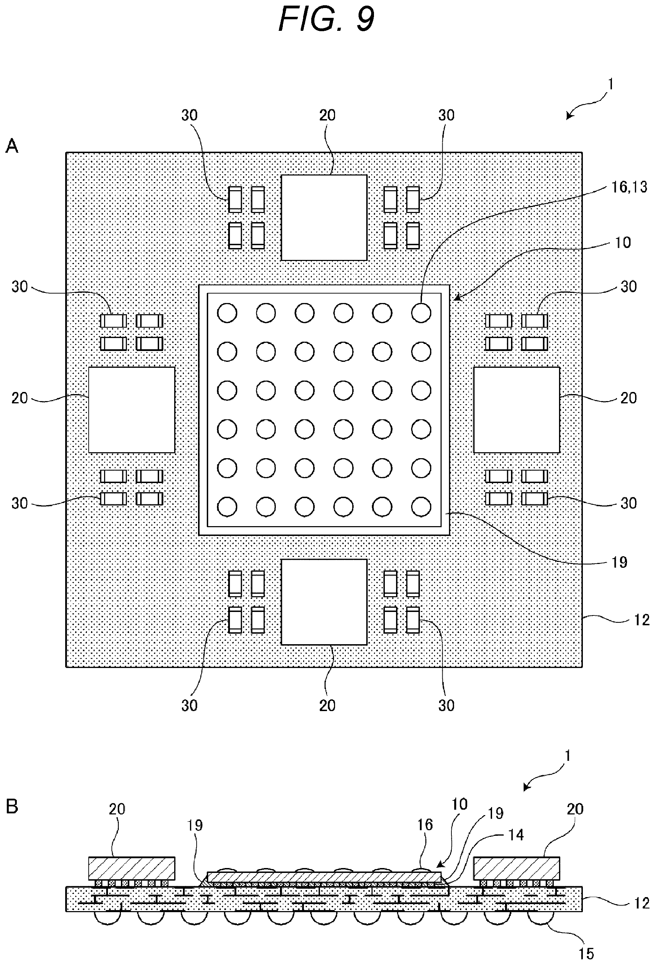

Fig. 9 is a diagram illustrating a basic configuration example of a package structure of a semiconductor laser driving apparatus according to a second embodiment. As illustrated in Figs. 9A and 9B, the VCSEL 10 of the semiconductor laser driving apparatus 1 is disposed substantially in the center on the package. Four LDDs 20 are disposed to face each other surrounding the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 9 in the present embodiment is different from the configuration of Fig. 4 described above in terms of the four LDDs 20 and the circuit configuration. Other configurations are the same as those in Fig. 4. Therefore, description of the sectional view of Fig. 9B is omitted.

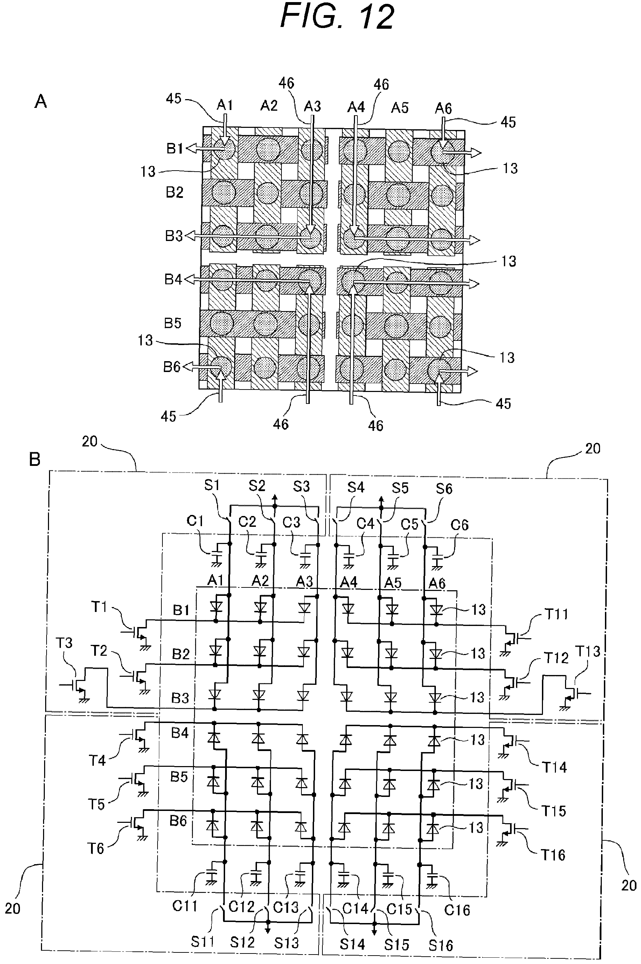

Next, the circuit configuration of the light-emitting element 13 will be described specifically. As illustrated in Figs. 12A and 12B, a total of 36 light-emitting elements 13 arranged in the VCSEL 10 are divided into four groups which are a group of the coordinates A1 to A3, B1 to B3, a group of the coordinates A4 to A6, B1 to B3, a group of the coordinates A1 to A3, B4 to B6, and a group of the coordinates A4 to A6, B4 to B6.

Then, in each of the groups, the positive electrodes of the three light-emitting elements 13 are electrically connected to each other in parallel as illustrated in Fig. 12B. Similarly, in the group, the negative electrodes of the three light-emitting elements 13 arranged in the horizontal direction are electrically connected to each other in parallel.

In the group of the coordinates A1 to A3, B1 to B3 and the group of the coordinates A4 to A6, B1 to B3, the positive electrodes of the three light-emitting elements 13 arranged in the vertical direction are connected to one ends of the switches S1 to S3 and S4 to S6 and the capacitors C1 to C3 and C4 to C6 at the coordinates A1 to A3 and the coordinates A4 to A6, respectively. Furthermore, the other ends of the switches S1 to S3 and S4 to S6 are connected to the power supply circuit.

Similarly, in the group of the coordinates A1 to A3, B4 to B6 and the group of the coordinates A4 to A6, B4 to B6, the positive electrodes of the three light-emitting elements 13 arranged in the vertical direction are connected to one ends of switches S11 to S13 and S14 to S16 and capacitors C11 to C13 and C14 to C16 at the coordinates A1 to A3 and the coordinates A4 to A6, respectively. Furthermore, the other ends of the switches S11 to S13 and S14 to S16 are connected to the power supply circuit.

In the group of the coordinates A1 to A3, B1 to B3 and the group of the coordinates A1 to A3, B4 to B6, the negative electrodes of the three light-emitting elements 13 arranged in the horizontal direction are connected to each other in parallel for every group, and the negative electrodes are respectively connected to the drains of the driving elements (for example, MOS FETs) T1 to T3 and T4 to T6 built in the LDD 20. In addition, the sources of the driving elements T1 to T3 and T4 to T6 are connected to the ground.

Similarly, in the group of the coordinates A4 to A6, B1 to B3 and the group of the coordinates A4 to A6, B4 to B6, the negative electrodes of the three light-emitting elements 13 arranged in the horizontal direction are connected to each other in parallel for every group, and the negative electrodes are respectively connected to the drains of the driving elements T11 to T13 and T14 to T16 built in the LDD 20. In addition, the sources of the driving elements T11 to T13 and T14 to T16 are connected to the ground.

Next, a sequence of causing the light-emitting element 13 of the VCSEL 10 to emit light will be described with reference to Fig. 12, considering the light-emitting element 13 connected to the coordinates A1, B1 for example. (1) First, the switch S1 is turned on to charge the capacitor C1. (2) Next, the driving element T1 is turned on. (3) Accordingly, current flows through the light-emitting element 13 connected to the coordinates A1, B1 to emit light. (4) The driving element T1 is turned off. As a result, current does not flow through the light-emitting element 13, and light emission stops. In this case, the current takes a path of the coordinate A1, the light-emitting element 13, and the coordinate B1 as indicated by an arrow 45 in Fig. 12A. Note that the light-emitting elements 13 connected to the coordinates A1, B6, the coordinates A6, B1, and the coordinates A6, B6 are configured in a similar manner. (5) Furthermore, individual light emission control can be performed by performing (2) to (4) for the desired light-emitting element 13 in a state where (1) is performed.

Next, the light-emitting element 13 connected to the coordinates A3, B3 will be described as an example. (1) First, the switch S3 is turned on to charge the capacitor C3. (2) Next, the driving element T3 is turned on. (3) Accordingly, current flows through the light-emitting element 13 connected to the coordinates A3, B3 to emit light. (4) The driving element T3 is turned off. As a result, current does not flow through the light-emitting element 13, and light emission stops. In this case, the current takes a path of the coordinate A3, the light-emitting element 13, and the coordinate B3 as indicated by an arrow 46 in Fig. 12A. Note that the light-emitting elements 13 connected to the coordinates A3, B4, the coordinates A4, B3, and the coordinates A4, B4 are configured in a similar manner.

As described above, in the basic configuration example of the second embodiment, the current flows in the path passing through one light-emitting element 13 indicated by the arrow 45 in the light-emitting element 13 connected to the coordinates A1, B1, whereas the current flows in the path passing through five light-emitting elements 13 indicated by the arrow 46 in the light-emitting element 13 connected to the coordinates A3, B3. That is, the ratio of the shortest path to the longest path of the wiring length for causing current to flow is 2:6. In addition, the difference in wiring length is 6 - 2 = 4. As described above, the wiring length is improved to 6/12 and the difference in wiring length is improved to 4/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

The above description is about a case of the group of the coordinates A1 to A3, B1 to B3, and the other groups are similar. Then, the improvement effects described above can be obtained.

### [First modification of second embodiment]

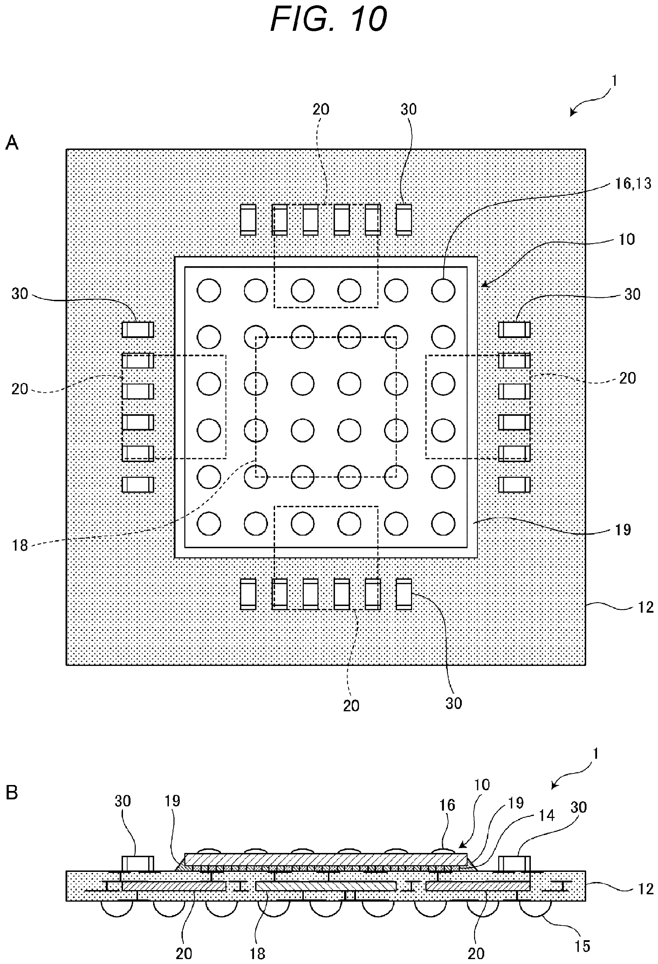

Fig. 10 is a diagram illustrating a first modification of the package structure of the semiconductor laser driving apparatus according to the second embodiment. As illustrated in Figs. 10A and 10B, the VCSEL 10 of the semiconductor laser driving apparatus 1 is disposed substantially in the center on the package. Four LDDs 20 are disposed to face each other surrounding the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 10 in the present embodiment and the basic configuration example according to the second embodiment illustrated in Fig. 9 described above are different in that four LDDs 20 are built in the substrate 12 and a heat dissipation member 18 is provided in the substrate 12. Other configurations are the same as those of the first modification of the first embodiment illustrated in Fig. 5 described above. Furthermore, the heat dissipation member 18 is similar to those of the first modification of the first embodiment illustrated in Fig. 5. Therefore, description of the sectional view of Fig. 10B is omitted.

Next, the circuit configuration of the light-emitting element 13 will be described. As illustrated in Figs. 12A and 12B, a total of 36 light-emitting elements 13 arranged in the VCSEL 10 are divided into four groups which are a group of the coordinates A1 to A3, B1 to B3, a group of the coordinates A4 to A6, B1 to B3, a group of the coordinates A1 to A3, B4 to B6, and a group of the coordinates A4 to A6, B4 to B6. This is the same as the basic configuration example of the second embodiment described above. Therefore, description of the circuit configuration is omitted.

Next, the 36 light-emitting elements 13 arranged in a matrix of the VCSEL 10 are divided into four groups as described above, and the circuit configuration of each light-emitting element 13 and a sequence of causing the light-emitting element 13 to emit light are similar to those of the basic configuration example of the second embodiment. Therefore, description of the circuit configuration and the sequence is omitted.

As described above, as for the wiring length for causing current to flow, in a similar manner to the basic configuration example of the second embodiment, in the first modification, the current flows in the path passing through one light-emitting element 13 indicated by the arrow 45 in the light-emitting element 13 connected to the coordinates A1, B1, whereas the current flows in the path passing through five light-emitting elements 13 indicated by the arrow 46 in the light-emitting element 13 connected to the coordinates A3, B3. That is, the ratio of the shortest path to the longest path of the wiring length for causing current to flow is 2:6. In addition, the difference in wiring length is 6 - 2 = 4. As described above, the wiring length is improved to 6/12 and the difference in wiring length is improved to 4/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

The above description is about a case of the group of the coordinates A1 to A3, B1 to B3, and the other groups are similar. Then, the improvement effects described above can be obtained.

### [Second modification of second embodiment]

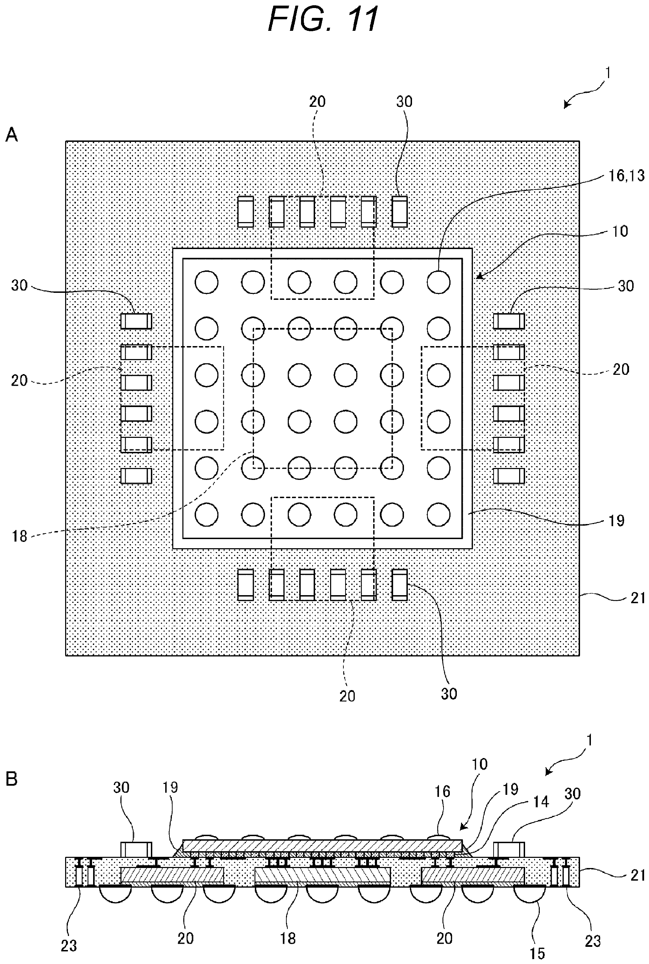

Fig. 11 is a diagram illustrating a second modification of the package structure of the semiconductor laser driving apparatus according to the second embodiment. As illustrated in Figs. 11A and 11B, the VCSEL 10 of the semiconductor laser driving apparatus 1 is disposed substantially in the center on the package. Four LDDs 20 are disposed to face each other surrounding the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 11 in the present embodiment and the basic configuration example according to the second embodiment illustrated in Fig. 9 described above are different in that the package structure has four LDDs 20 disposed in the FOWLP 21 and that the heat dissipation member 18 is provided. The other configurations and the circuit configuration of the light-emitting elements 13 are the same as those in the case of Fig. 9. That is, the light-emitting elements 13 are divided into four groups which are the group of the coordinates A1 to A3, B1 to B3, the group of the coordinates A4 to A6, B1 to B3, the group of the coordinates A1 to A3, B4 to B6, and the group of the coordinates A4 to A6, B4 to B6.

A package structure in which the four LDDs 20 illustrated in Fig. 11 in the present embodiment are arranged in the FOWLP 21 is the same as the package structure in which the two LDDs 20 illustrated in Fig. 6 in the second modification of the first embodiment are arranged in the FOWLP 21. Furthermore, the heat dissipation member 18 is similar to those of the first modification of the first embodiment illustrated in Fig. 5. Therefore, description of the heat dissipation member 18 is omitted.

Then, a circuit configuration of each light-emitting element 13 and a sequence of causing the light-emitting element 13 to emit light are similar to the basic configuration example of the second embodiment illustrated in Figs. 12A and 12B. Therefore, description of the circuit configuration of each light-emitting element 13 and description of the sequence are omitted.

As described above, as for the wiring length for causing current to flow, in a similar manner to the basic configuration example of the second embodiment, in the second modification, the current flows in the path passing through one light-emitting element 13 indicated by the arrow 45 in the light-emitting element 13 connected to the coordinates A1, B1, whereas the current flows in the path passing through five light-emitting elements 13 indicated by the arrow 46 in the light-emitting element 13 connected to the coordinates A3, B3. That is, the ratio of the shortest path to the longest path of the wiring length for causing current to flow is 2:6. In addition, the difference in wiring length is 6 - 2 = 4. As described above, the wiring length is improved to 6/12 and the difference in wiring length is improved to 4/10 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

The above description is about a case of the group of the coordinates A1 to A3, B1 to B3, and the other groups are similar. Then, the improvement effects described above can be obtained.

### <4. Configuration example of package structure of semiconductor laser driving apparatus according to third embodiment>

### [Basic configuration example of third embodiment]

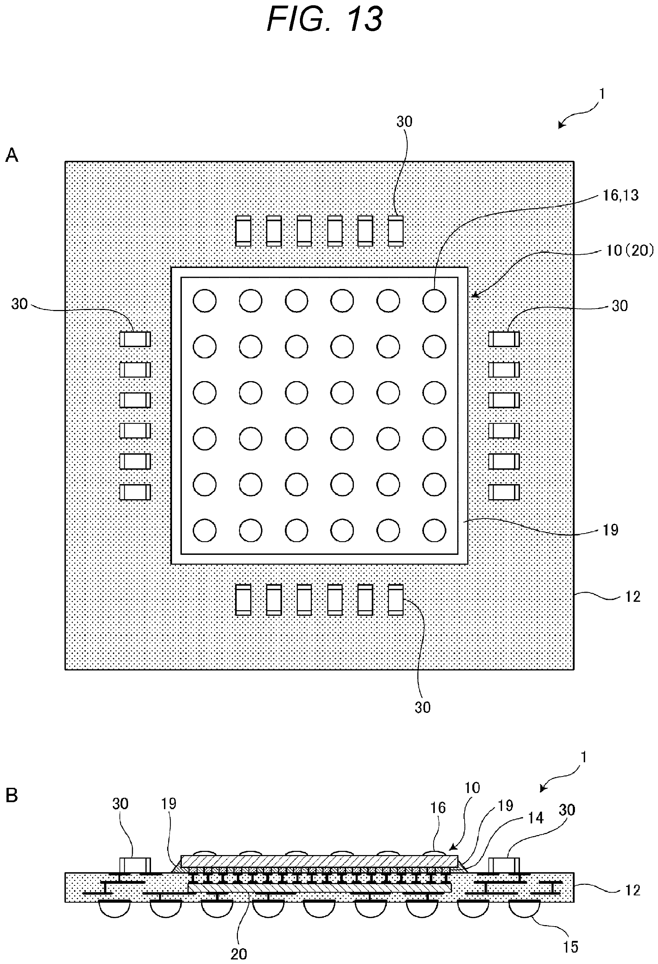

Fig. 13 is a diagram illustrating a basic configuration example of a package structure of a semiconductor laser driving apparatus according to a third embodiment. As illustrated in Figs. 13A and 13B, the VCSEL 10 of the semiconductor laser driving apparatus 1 is disposed substantially in the center on the package. One LDD 20 having substantially the same contour as the VCSEL 10 is disposed in the substrate 12 immediately under the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, the periphery of the VCSEL 10 is sealed by the underfill 19.

A configuration of Fig. 13 in the present embodiment and the basic configuration example illustrated in Fig. 2 described above are common in that there is one LDD 20. On the other hand, the configuration of Fig. 13 in the present embodiment is different from the basic configuration example illustrated in Fig. 2 in that the LDD 20 is disposed immediately under the VCSEL 10, and moreover in the substrate 12, and that the LDD 20 has substantially the same size as the VCSEL 10, and the circuit configurations are different.

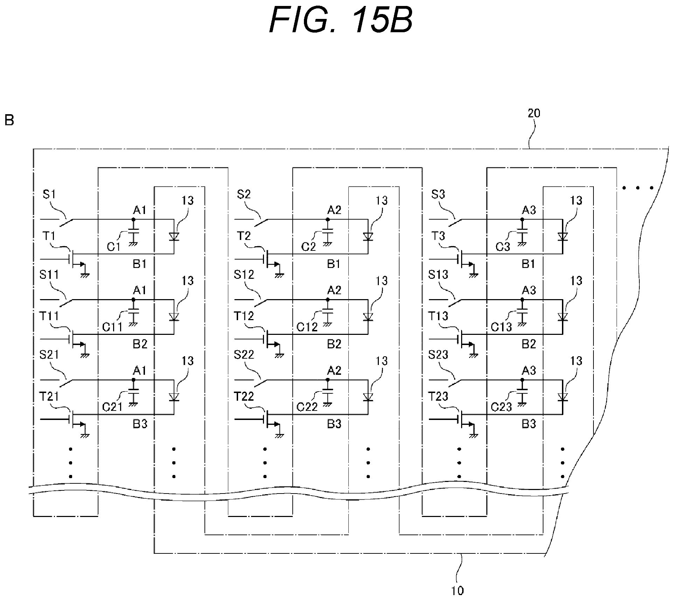

Hereinafter, the structure will be described. As illustrated in the sectional view of Fig. 13B, each light-emitting element 13 is electrically connected to the substrate 12 by the connection electrode 14. For example, the substrate 12 is provided with a wiring layer, and the negative electrode of each light-emitting element 13 is connected on a one-to-one basis to each of the drains of the driving elements T1 to T36 of the LDD 20 disposed immediately under the VCSEL 10 by the connection via 22 (not shown) formed in the wiring layer as illustrated in the circuit diagram of Fig. 15B.

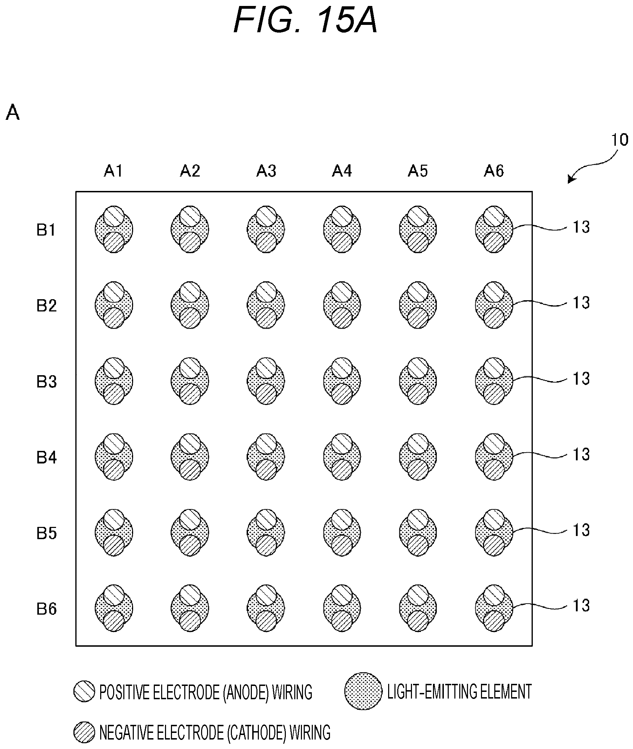

That is, as illustrated in an arrangement diagram of Fig. 15A, the size of the LDD 20 is substantially the same as the size of the VCSEL 10, and the 36 driving elements T1 to T36 of the LDD 20 are respectively arranged immediately under the 36 light-emitting elements 13 arranged in a matrix. Then, the driving elements T1 to T36 are configured to drive the light-emitting elements 13 on a one-to-one basis.

The positive electrode of each light-emitting element 13 is connected to one end of each of the switches S1 to S36 and the positive electrode of each of the capacitors C1 to C36. The negative electrodes of the capacitors C1 to C36 are connected to the ground. Furthermore, the other ends of the switches S1 to S36 are connected to the power supply circuit.

The negative electrodes of the light-emitting elements 13 are connected to the drains of the driving elements (MOS FETs) T1 to T36, respectively. Then, the sources of the driving elements (MOS FETs) T1 to T36 are connected to the ground. In addition, an input signal or the like from outside of the LDD 20 is electrically connected to the external terminal 15 via the wiring layer of the substrate 12.

Next, a sequence of causing the light-emitting element 13 of the VCSEL 10 to emit light will be described on the basis of the circuit diagram of Fig. 15B, considering the light-emitting element 13 connected to the coordinates A1, B1 for example. (1) First, the switch S1 is turned on to charge the capacitor C1. (2) Next, the driving element T1 is turned on. (3) Accordingly, current flows through the light-emitting element 13 connected to the coordinates A1, B1 to emit light. (4) The driving element T1 is turned off. As a result, current does not flow through the light-emitting element 13, and light emission stops. In this case, the current takes a path in which the current flows in from the positive electrode (anode wiring) at the coordinates A1, B1 in Fig. 15A and returns to the ground via the negative electrode (cathode wiring). Note that the other light-emitting elements 13 connected to the coordinates A2, B2 to A6, B6 are configured in a similar manner, and thus, the description the light-emitting elements 13 will be omitted. (5) Furthermore, individual light emission control can be performed by performing (2) to (4) for the desired light-emitting element 13 in a state where (1) is performed.

As described above, in the basic configuration example of the third embodiment, as for the light-emitting elements 13 connected to the coordinates A1, B1, the current takes a path in which the current flows in from the positive electrode (anode wiring) at the coordinates A1, B1 in Fig. 15A and returns to the ground via the negative electrode (cathode wiring).

That is, the wiring length for causing current to flow is the same and is 1 for any light-emitting element 13. Therefore, the ratio of the shortest path to the longest path of the wiring length is 1:1. In addition, the difference in wiring length is 1 - 1 = 0. As described above, the wiring length is improved to 1/12 and the difference in wiring length is improved to 0 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

Note that, since the driving elements T1 to T36 are configured to drive the light-emitting elements 13 on a one-to-one basis, the light-emitting elements 13 can be cyclically driven one by one in the order of arrangement, or can be randomly driven. In addition, a plurality of light-emitting elements 13 can be driven simultaneously, and all variations of laser irradiation can be achieved.

### [Modification of third embodiment]

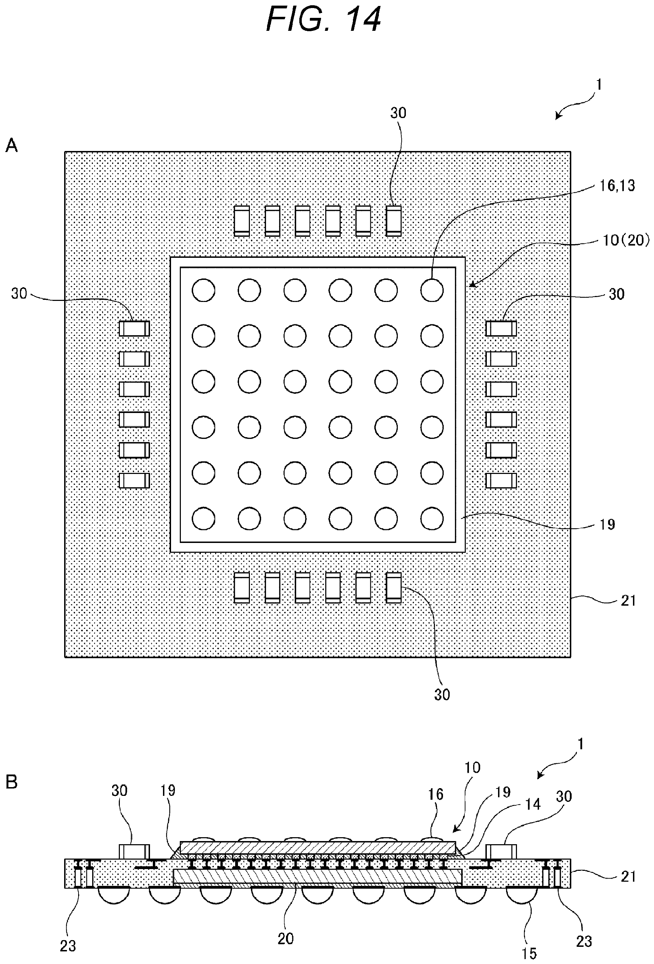

Fig. 14 is a diagram illustrating a modification of the package structure of the semiconductor laser driving apparatus according to the third embodiment. As illustrated in Figs. 14A and 14B, the VCSEL 10 of the semiconductor laser driving apparatus 1 is disposed substantially in the center on the package. One LDD 20 having substantially the same contour as the VCSEL 10 is disposed in the substrate 12 immediately under the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 14 in the present embodiment and the basic configuration example according to the third embodiment illustrated in Fig. 13 described above are different in that one LDD 20 having substantially the same contour as the VCSEL 10 is disposed in the FOWLP 21 in the package structure. The other configurations are the same as those in the case of Fig. 13. Therefore, description of the heat dissipation member 18 is omitted.

Furthermore, the circuit configuration of the light-emitting elements 13 is the same as that in the case of Fig. 15. Therefore, description of the circuit configuration is omitted. Furthermore, a circuit configuration of each light-emitting element 13 and a sequence of causing the light-emitting element 13 to emit light are similar to those of the basic configuration example of the third embodiment. Therefore, description of the sequence is omitted.

As described above, in the modification of the third embodiment, as for the light-emitting elements 13 connected to the coordinates A1, B1, the current takes the path in which the current flows in from the positive electrode (anode wiring) at the coordinates A1, B1 in Fig. 15A and returns to the ground via the negative electrode (cathode wiring).

That is, the wiring length for causing current to flow is the same and is 1 for any light-emitting element 13. Therefore, the ratio of the shortest path to the longest path of the wiring length is 1:1. In addition, the difference in wiring length is 1 - 1 = 0. As described above, the wiring length is improved to 1/12 and the difference in wiring length is improved to 0 as compared with the case of Fig. 3. Therefore, since the signal propagation delay due to the difference in the wiring length and the wiring length from the LDD 20 to the light-emitting element 13 can be reduced, inductance due to a wiring loop is reduced, the rise/fall time of the drive waveform of the VCSEL 10 is reduced, and the waveform distortion can be improved.

Note that, since the driving elements T1 to T36 are configured to drive the light-emitting elements 13 on a one-to-one basis in a similar manner to the case of the basic configuration example of the third embodiment, the light-emitting elements 13 can be cyclically driven one by one in the order of arrangement, or can be randomly driven. In addition, a plurality of light-emitting elements 13 can be driven simultaneously, and all variations of laser irradiation can be achieved.

### <5. Configuration example of package structure of semiconductor laser driving apparatus according to fourth embodiment>

### [Basic configuration example of fourth embodiment]

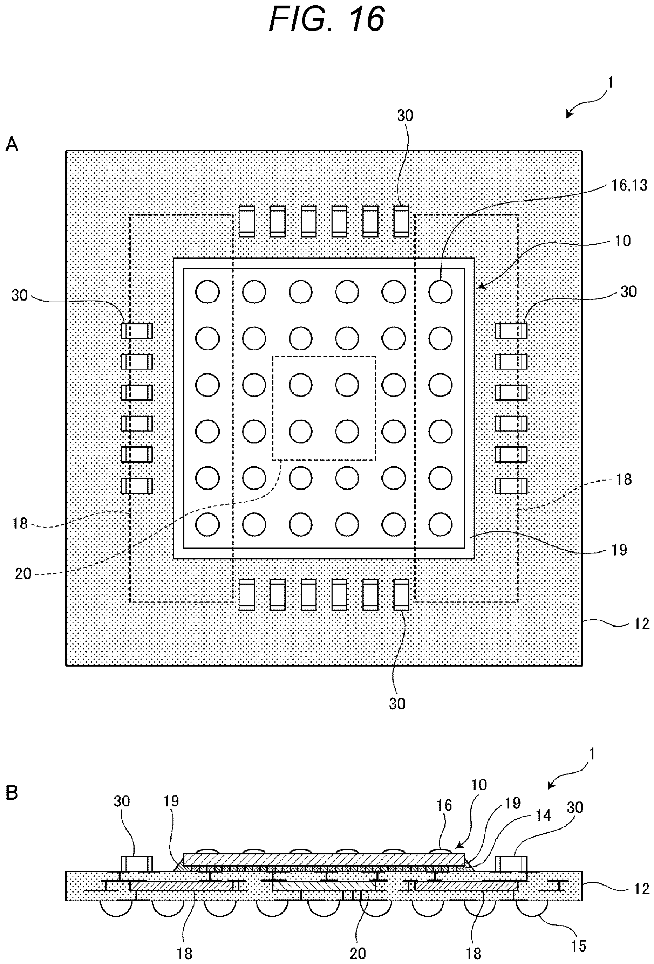

Fig. 16 is a diagram illustrating a basic configuration example of a package structure of a semiconductor laser driving apparatus according to a fourth embodiment. As illustrated in Figs. 16A and 16B, the VCSEL 10 of the semiconductor laser driving apparatus 1 is disposed substantially in the center on the package. One LDD 20 is disposed in the substrate 12 immediately under a substantially center of the VCSEL 10. Then, a capacitor 30 is disposed around the VCSEL 10. The VCSEL 10 is configured such that light-emitting elements 13 that emit laser light are arranged in a lattice (matrix) on a substrate 12. Similarly to a case in Fig. 2, this drawing illustrates an example in which a total of 36 light-emitting elements 13 including 6 vertical and 6 horizontal light-emitting elements are arranged in a matrix.

In addition, on an upper surface of each light-emitting element 13, similarly to the case of Fig. 2, the MLA 16 is formed in a matrix corresponding to the arrangement of each light-emitting element 13. Then, a periphery of the VCSEL 10 is sealed by an underfill 19.

A configuration of Fig. 16 in the present embodiment and the basic configuration example Fig. 2 described above are common in that there is one LDD 20. On the other hand, the configuration is different in that the LDD 20 is disposed immediately under the substantially center of the VCSEL 10, that the LDD 20 is disposed in the substrate 12, and that two heat dissipation members 18 and 18 are disposed in the substrate 12 across the LDD 20 on the left and right of the LDD 20. In addition, the configuration of Fig. 16 is different from the configuration of Fig. 13 in the basic configuration example of the third embodiment described above in that the size of the LDD 20 is smaller than the size of the VCSEL 10, the two heat dissipation members 18 are disposed in the substrate 12, and the circuit configurations are different. Other configurations are the same as the basic configuration example of the third embodiment illustrated in Fig. 13 described above. Furthermore, the heat dissipation member 18 is similar to those of the first modification of the first embodiment illustrated in Fig. 5. Therefore, description of the sectional view of Fig. 16B is omitted.

Next, the circuit configuration will be described. In the present embodiment, since the LDD 20 is disposed immediately under the VCSEL 10, the wiring length can be reduced. Therefore, by changing the number of the driving elements T1 to T36 built in the LDD 20 depending on a wiring method, it is possible to cope with any of the circuit configurations of Figs. 3B, 7B, 12B, and 15B described above. Here, an example of configuring by the circuit of Fig. 3B will be described.

In a circuit example of Fig. 3B, the positive electrodes of the six light-emitting elements 13 arranged in the vertical direction at the coordinates B1 to B6 are electrically connected to each other in parallel. Similarly, as illustrated in Figs. 3A and 3B, the negative electrodes of the six light-emitting elements 13 of coordinates A1 to A6 arranged in the horizontal direction are electrically connected to each other in parallel.

The positive electrodes of the six light-emitting elements 13 arranged in the vertical direction at the coordinates B1 to B6 are connected to one ends of switches S1 to S6 and positive electrodes of the capacitors C1 to C6, respectively, arranged at the coordinates A1 to A6. Furthermore, negative electrodes of the capacitors C1 to C6 are connected to a ground. However, in a case where nonpolar capacitors are used, the polarity of the positive electrode, the negative electrodes, or the like does not matter. Then, the other ends of the switches S1 to S6 are connected to the power supply circuit.

The negative electrodes of the six light-emitting elements 13 arranged in the horizontal direction are connected to the drains of the driving elements T1 to T6 of the LDD 20 arranged at the coordinates B1 to B6, respectively. In addition, sources of the driving elements T1 to T6 are connected to the ground. Then, each of the light-emitting elements 13 is configured such that each of the driving elements T1 to T6 is driven by selecting any of the coordinates A1 to A6 and B1 to B6. In addition, an input signal or the like from outside of the LDD 20 is electrically connected to the external terminal 15 via the wiring layer of the substrate 12.

As described above, on the circuit diagram, the circuit configuration in the present embodiment is the same as the circuit configuration of Fig. 3B. However, the connection between the light-emitting elements 13 and the driving elements T1 to T6 of the LDD 20 can have an aspect different from the description of Fig. 3.

Fig. 18 is an example of a case where the light-emitting elements 13 are arranged as in Fig. 3A, the circuit diagram is the same as in Fig. 3B, but actual wiring is connected in a different manner from Fig. 3B. As illustrated in Fig. 18, the driving elements T1 to T3 of the LDD 20 are arranged in the horizontal direction at the coordinates A3 to A4, B3. Then, the driving element T1 is connected to the metal layer 24 of the coordinates A3, B1 in which the negative electrodes of the light-emitting elements 13 are electrically connected to each other in parallel in the horizontal direction. Furthermore, the driving element T2 is connected to the metal layer 24 of the coordinates A4, B2 in which the negative electrodes of the light-emitting elements 13 are electrically connected to each other in parallel in the horizontal direction. Similarly, the driving element T3 is connected to the metal layer 24 of the coordinates A5, B3 in which the negative electrodes of the light-emitting elements 13 are electrically connected to each other in parallel in the horizontal direction.

In addition, as illustrated in Fig. 18, the driving elements T4 to T6 of the LDD 20 are arranged in the horizontal direction at the coordinates A3 to A4, B4. Then, the driving element T4 is connected to the metal layer 24 of the coordinates A2, B4 in which the negative electrodes of the light-emitting elements 13 are electrically connected to each other in parallel in the horizontal direction. Furthermore, the driving element T5 is connected to the metal layer 24 of the coordinates A4, B5 in which the negative electrodes of the light-emitting elements 13 are electrically connected to each other in parallel in the horizontal direction. Similarly, the driving element T6 is connected to the metal layer 24 of the coordinates A4, B6 in which the negative electrodes of the light-emitting elements 13 are electrically connected to each other in parallel in the horizontal direction. Note that the wiring is desirably routed so as to optimize the difference between the shortest path and the longest path and the wiring length. That is, as for the driving elements T1 to T6 are connected to the metal layer 24, it is sufficient to decide which of the coordinates A1 to A6, B1 to B6 of the metal layer 24 the driving elements T1 to T6 are to be connected to while checking a balance between the shortest path and the longest path.

In a connection state between each light-emitting element 13 and each of the driving elements T1 to T6 as described above, the circuit configuration of each light-emitting element 13 and the sequence of causing the light-emitting element 13 to emit light are similar to the example of the package structure of the semiconductor laser driving apparatuses in Fig. 3A and 3B described above. Therefore, description of the sequence is omitted.

Since the basic configuration example of the present embodiment is configured as described above, for example, the current flows through the light-emitting element 13 at the coordinates A6, B1 connected to the driving element T1 through a path passing through five light-emitting elements 13 as illustrated by an arrow 47 as illustrated in Fig. 18, whereas the current flows through the light-emitting element 13 at the coordinates A5, B3 connected to the driving element T3 through a path passing through one light-emitting element 13 as illustrated by an arrow 48. That is, the wiring length for causing current to flow is 5 in the former case and 1 in the latter case. Therefore, the ratio of the shortest path to the longest path of the wiring length for causing current to flow is 1:5. In addition, the difference in wiring length is 5 - 1 = 4. In this manner, in spite of the same circuit configuration as the circuit configuration of Fig. 3, since the LDD 20 is disposed immediately under the VCSEL 10 in the present embodiment, the wiring length can be reduced. As described above, the wiring length is improved to 5/12 and the difference in wiring length is improved to 4/10 as compared with the case of Fig. 3.

In addition, since the signal propagation delay due to the difference in the wiring length and the wiring length from the LDD 20 to the light-emitting element 13 can be therefore reduced, the inductance due to the wiring loop is reduced, the rise/fall time of the drive waveform of the VCSEL 10 is reduced, and the waveform distortion can be improved.

Furthermore, in the present embodiment, since one LDD 20 is disposed in the substrate 12 immediately under the substantially center of the VCSEL 10, the driving elements T1 to T6 can be connected to each other at any portion of the circuit of the coordinates B1 to B6 in which the negative electrodes are electrically connected to each other in parallel in the horizontal direction. Thus, the difference between the shortest path and the longest path can be freely adjusted. Therefore, optimum improvement effects can be obtained. In addition, the effects can be achieved with a simple circuit configuration without increasing the number of driving elements T1 to T6.

Furthermore, in the present embodiment, one LDD 20 is disposed in the substrate 12 immediately under the substantially center of the VCSEL 10. Thus, in a similar manner to the description of Fig. 15 in the third embodiment described above, the driving elements T1 to T36 can be built in the LDD 20, and each of the driving elements T1 to T36 and each of the light-emitting elements 13 can be connected to each other on a one-to-one basis. That is, any connection form can be adopted, and thus optimal improvement effects can be selected and obtained.

### [Modification of fourth embodiment]

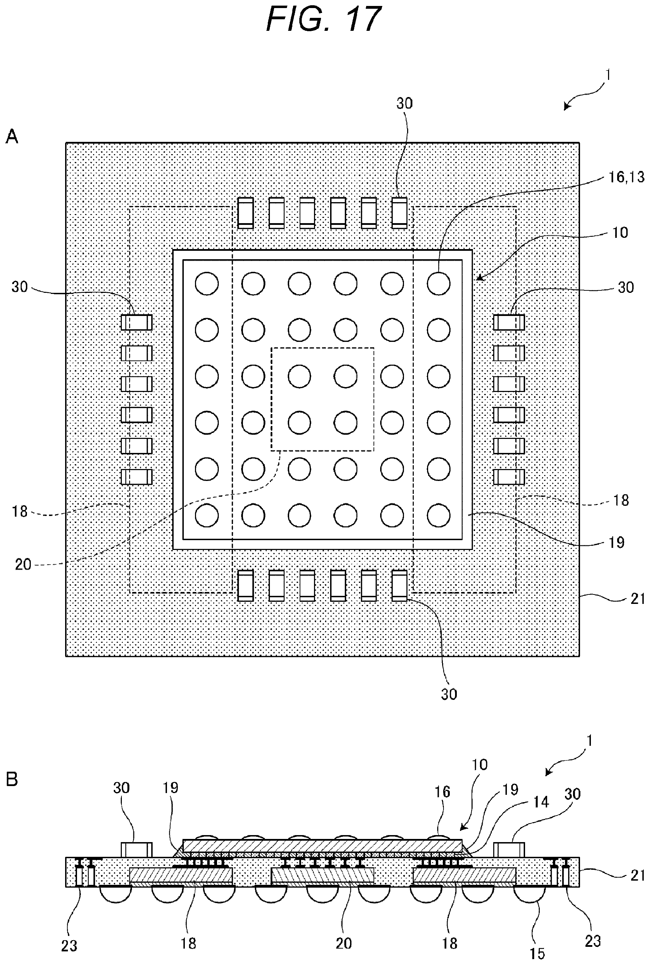

Fig. 17 is a diagram illustrating a modification of a package structure of a semiconductor laser driving apparatus according to a fourth embodiment. A configuration of Fig. 17 in the present embodiment and the configuration of Fig. 16 in the basic configuration example described above are common in that there is one LDD 20, the size of the LDD 20 is the same, the LDD 20 is immediately under the substantially center of the VCSEL 10, and that two heat dissipation members 18 are disposed in the package. On the other hand, the configuration of Fig. 17 in the present embodiment is different from the configuration of Fig. 16 in the basic configuration example in that the package structure is the FOWLP 21. Other configurations are the same as those in the case of Fig. 16. Furthermore, the heat dissipation member 18 is similar to those of the first modification of the first embodiment illustrated in Fig. 5. Therefore, description of the configuration of the heat dissipation member 18 is omitted.

Furthermore, the circuit configuration of the modification of the present embodiment is the same as in Fig. 18 in the basic configuration example of the present embodiment. Then, in the modification of the present embodiment, since the LDD 20 is disposed immediately under the VCSEL 10, the wiring length can be reduced. Therefore, in a similar manner to the basic configuration example of the present embodiment, by changing the number of the driving elements T1 to T36 built in the LDD 20 depending on the wiring method, it is possible to cope with any of the circuit configurations of Figs. 3B, 7B, 12B, and 15B described above. Therefore, description of the circuit configuration and a circuit operation is omitted.

Since the present embodiment is configured as described above, effects similar to those described in the basic configuration example of the fourth embodiment can be obtained. That is, the wiring length for causing current to flow is 5 in the former case and 1 in the latter case. Therefore, the ratio of the shortest path to the longest path of the wiring length for causing current to flow is 1:5. In addition, the difference in wiring length is 5 - 1 = 4.

### <6. Configuration example of vehicle control system including semiconductor laser driving apparatus according to present technology>

The technology of the semiconductor laser driving apparatus of the present disclosure can be applied to various products. For example, the technology according to the present disclosure may be achieved as an apparatus mounted on any type of vehicle such as an automobile, an electric vehicle, a hybrid electric vehicle, a motorcycle, a bicycle, a construction machine, or an agricultural machine (tractor), or a mobile body such as a personal mobility, an airplane, a drone, a ship, or a robot.

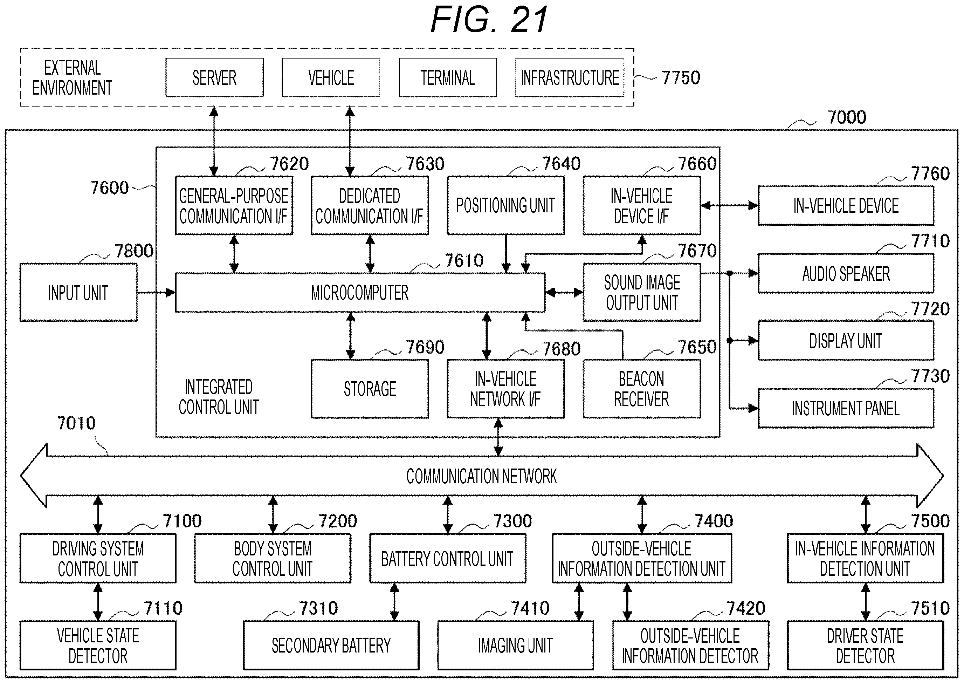

Fig. 21 is a block diagram illustrating an example of a schematic configuration of the vehicle control system 7000 as an example of a mobile body control system to which the technology of the present disclosure can be applied. The vehicle control system 7000 includes a plurality of electronic control units connected to each other via a communication network 7010. In the example illustrated in Fig. 21, the vehicle control system 7000 includes a driving system control unit 7100, a body system control unit 7200, a battery control unit 7300, the outside-vehicle information detection unit 7400, an in-vehicle information detection unit 7500, and an integrated control unit 7600. The communication network 7010 connecting the plurality of control units may be, for example, an in-vehicle communication network conforming to any standard such as a controller area network (CAN), a local interconnect network (LIN), a local area network (LAN), or FlexRay (registered trademark).

Each of the control units includes a microcomputer that performs arithmetic processing in accordance with various programs, a storage that stores programs executed by the microcomputer, parameters used for various calculations, or the like, and a drive circuit that drives various devices to be controlled. Each of the control units includes a network I/F for communicating with other control units via the communication network 7010, and a communication I/F for communicating with devices, sensors, or the like inside and outside the vehicle by wired communication or wireless communication. As a functional configuration of the integrated control unit 7600, Fig. 21 illustrates a microcomputer 7610, a general-purpose communication I/F 7620, a dedicated communication I/F 7630, a positioning unit 7640, a beacon receiver 7650, an in-vehicle device I/F 7660, a sound image output unit 7670, an in-vehicle network I/F 7680, and a storage 7690. The other control units similarly include a microcomputer, a communication I/F, a storage, and the like.

The driving system control unit 7100 controls operation of devices related to a driving system of the vehicle in accordance with various programs. For example, the driving system control unit 7100 functions as a control device for a driving force generating device for generating a driving force of the vehicle, such as an internal combustion engine, a driving motor, or the like, a driving force transmitting mechanism for transmitting the driving force to wheels, a steering mechanism for adjusting a steering angle of the vehicle, a braking device for generating the braking force of the vehicle, and the like. The driving system control unit 7100 may have a function as a control device such as an antilock brake system (ABS) or an electronic stability control (ESC).

A vehicle state detector 7110 is connected to the driving system control unit 7100. The vehicle state detector 7110 includes, for example, at least one of a gyro sensor that detects an angular velocity of axial rotational motion of a vehicle body, an acceleration sensor that detects acceleration of the vehicle, or a sensor that detects an operation amount of an accelerator pedal, an operation amount of a brake pedal, a steering angle of a steering wheel, an engine speed, a wheel rotation speed, or the like. The driving system control unit 7100 performs arithmetic processing by using a signal input from the vehicle state detector 7110, and controls the internal combustion engine, the driving motor, an electric power steering device, a brake device, or the like.

The body system control unit 7200 controls the operation of various kinds of devices provided to a vehicle body in accordance with various programs. For example, the body system control unit 7200 functions as a control device for a keyless entry system, a smart key system, a power window device, or various lamps such as a headlamp, a backup lamp, a brake lamp, a turn signal, a fog lamp, or the like. In this case, radio waves transmitted from a mobile device as an alternative to a key or signals of various switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source of the driving motor, in accordance with various programs. For example, information regarding a battery temperature, a battery output voltage, a battery level of a battery, and the like is input to the battery control unit 7300 from a battery device including the secondary battery 7310. The battery control unit 7300 performs arithmetic processing by using these signals, and performs temperature adjustment control of the secondary battery 7310 or control of a cooling device or the like included in the battery device.

The outside-vehicle information detection unit 7400 detects information regarding the outside of the vehicle including the vehicle control system 7000. For example, at least one of an imaging unit 7410 or the outside-vehicle information detector 7420 is connected to the outside-vehicle information detection unit 7400. The imaging unit 7410 includes at least one of a time of flight (ToF) camera, a stereo camera, a monocular camera, an infrared camera, or other cameras. The outside-vehicle information detector 7420 includes, for example, at least one of an environment sensor for detecting current weather or weather, or a surrounding information detection sensor for detecting another vehicle, an obstacle, a pedestrian, or the like around the vehicle on which the vehicle control system 7000 is mounted.

The environment sensor may be, for example, at least one of a raindrop sensor that detects rainy weather, a fog sensor that detects fog, a sunshine sensor that detects a degree of sunshine, or a snow sensor that detects snowfall. The surrounding information detection sensor may be at least one of an ultrasonic sensor, a radar device, or a light detection and ranging, laser imaging detection and ranging (LIDAR) device. The imaging unit 7410 and the outside-vehicle information detector 7420 may be provided as independent sensors or devices, or may be provided as a device in which a plurality of sensors or devices is integrated.

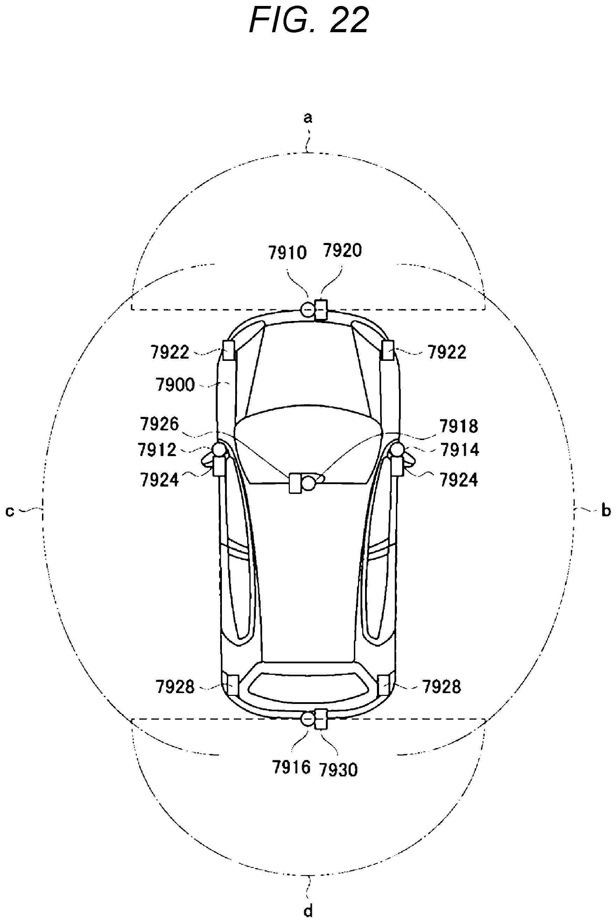

Here, Fig. 22 illustrates an example of installation positions of the imaging unit 7410 and the outside-vehicle information detector 7420. Imaging units 7910, 7912, 7914, 7916, and 7918 are, for example, disposed at at least one position of a front nose, sideview mirrors, a rear bumper, a back door of the vehicle 7900, or an upper portion of a windshield within an interior of the vehicle. The imaging unit 7910 provided at the front nose and the imaging unit 7918 provided at the upper portion of the windshield within the interior of the vehicle obtain mainly an image of the front of the vehicle 7900. The imaging units 7912 and 7914 provided on the sideview mirrors obtain mainly an image of the sides of the vehicle 7900. The imaging unit 7916 provided to the rear bumper or the back door obtains mainly an image of the rear of the vehicle 7900. The imaging unit 7918 provided to the upper portion of the windshield within the interior of the vehicle is used mainly to detect a preceding vehicle, a pedestrian, an obstacle, a signal, a traffic sign, a lane, and the like.

Note that, Fig. 22 illustrates an example of imaging ranges of the imaging units 7910, 7912, 7914, and 7916. An imaging range a represents the imaging range of the imaging unit 7910 provided to the front nose. Imaging ranges b and c respectively represent the imaging ranges of the imaging units 7912 and 7914 provided to the sideview mirrors. An imaging range d represents the imaging range of the imaging unit 7916 provided to the rear bumper or the back door. A bird's-eye image of the vehicle 7900 as viewed from above is obtained by superimposing image data imaged by the imaging units 7910, 7912, 7914, and 7916, for example.

Outside-vehicle information detectors 7920, 7922, 7924, 7926, 7928, and 7930 provided at the front, rear, sides, corners, and the upper portion of the windshield in the interior of the vehicle 7900 may be, for example, ultrasonic sensors or radar devices. The outside-vehicle information detectors 7920, 7926, and 7930 provided at the front nose, the rear bumper, the back door, and the upper portion of the windshield in the interior of the vehicle 7900 may be, for example, LIDAR devices. The outside-vehicle information detectors 7920 to 7930 are mainly used for detecting a preceding vehicle, a pedestrian, an obstacle, or the like.

With reference to Fig. 21 again, the description will be continued. The outside-vehicle information detection unit 7400 makes the imaging unit 7410 image the image data of the outside of the vehicle, and receives the imaged image data. Furthermore, the outside-vehicle information detection unit 7400 receives detection information from the connected outside-vehicle information detector 7420. In a case where the outside-vehicle information detector 7420 is an ultrasonic sensor, a radar device, or a LIDAR device, the outside-vehicle information detection unit 7400 transmits ultrasonic waves, electromagnetic waves, or the like, and receives information regarding received reflected waves. On the basis of the received information, the outside-vehicle information detection unit 7400 may perform processing of detecting objects such as a human, a vehicle, an obstacle, a sign, a character on a road surface, and the like, or processing of detecting a distance thereto. The outside-vehicle information detection unit 7400 may perform environment recognition processing of recognizing rainfall, fog, road surface conditions, or the like on the basis of the received information. The outside-vehicle information detection unit 7400 may calculate a distance to an object outside the vehicle on the basis of the received information.

Furthermore, on the basis of the received image data, the outside-vehicle information detection unit 7400 may perform processing of recognizing images of a human, a vehicle, an obstacle, a sign, a character on a road surface, and the like, or processing of detecting a distance thereto. The outside-vehicle information detection unit 7400 may perform processing of distortion correction, alignment of the received image data, or the like, and combine image data captured by different imaging units 7410 to generate a bird's-eye view image or a panoramic image. The outside-vehicle information detection unit 7400 may perform processing of viewpoint conversion by using image data captured by different imaging units 7410.

The in-vehicle information detection unit 7500 detects information regarding the inside of the vehicle. A driver state detector 7510 that detects, for example, a state of a driver is connected to the in-vehicle information detection unit 7500. The driver state detector 7510 may include a camera that images the driver, a biological sensor that detects biological information regarding the driver, a microphone that collects sound in the interior of the vehicle, or the like. The biological sensor is provided, for example, on a seat surface, a steering wheel, or the like, and detects biological information regarding an occupant sitting on a seat or a driver holding the steering wheel. On the basis of detection information input from the driver state detector 7510, the in-vehicle information detection unit 7500 may calculate a degree of fatigue of the driver or a degree of concentration of the driver, or may determine whether or not the driver is dozing. The in-vehicle information detection unit 7500 may perform processing of canceling noise or the like from the collected sound signal.

The integrated control unit 7600 controls whole operation in the vehicle control system 7000 in accordance with various programs. An input unit 7800 is connected to the integrated control unit 7600. The input unit 7800 is achieved by, for example, a device such as a touch panel, a button, a microphone, a switch, or a lever that can be operated by an occupant for input. Data obtained by performing audio recognition on sound input by the microphone may be input to the integrated control unit 7600. The input unit 7800 may be, for example, a remote control device using infrared rays or other radio waves, or an external connection device such as a mobile phone or a personal digital assistant (PDA) corresponding to the operation of the vehicle control system 7000. The input unit 7800 may be, for example, a camera, and in this case, the occupant can input information by gesture. Alternatively, data obtained by detecting movement of a wearable device worn by the occupant may be input. Furthermore, the input unit 7800 may include, for example, an input control circuit or the like that generates an input signal on the basis of information input by the occupant or the like using the input unit 7800 described above and outputs the input signal to the integrated control unit 7600. By operating the input unit 7800, the occupant or the like inputs various data to the vehicle control system 7000 or instructs a processing operation.

The storage 7690 may include a read only memory (ROM) that stores various programs to be executed by the microcomputer, and a random access memory (RAM) that stores various parameters, calculation results, sensor values, or the like. Furthermore, the storage 7690 may be achieved by a magnetic storage device such as a hard disc drive (HDD), a semiconductor storage device, an optical storage device, a magneto-optical storage device, or the like.

The general-purpose communication I/F 7620 is a general-purpose communication I/F that mediates communication with various devices existing in an external environment 7750. The general-purpose communication I/F 7620 may implement a cellular communication protocol such as Global System of Mobile communications (GSM) (registered trademark), WiMAX (registered trademark), Long Term Evolution (LTE) (registered trademark), or LTE-Advanced (LTE-A), or other wireless communication protocols such as a wireless LAN (also referred to as Wi-Fi (registered trademark)) and Bluetooth (registered trademark). The general-purpose communication I/F 7620 may be connected to a device (for example, an application server or a control server) existing on an external network (for example, the Internet, a cloud network, or a company-specific network) via, for example, a base station or an access point. Furthermore, the general-purpose communication I/F 7620 may be connected to a terminal (for example, a terminal of a driver, a pedestrian, or a store, or a machine type communication (MTC) terminal) existing near the vehicle by using, for example, a peer to peer (P2P) technology.

The dedicated communication I/F 7630 is a communication I/F that supports a communication protocol formulated for use in a vehicle. The dedicated communication I/F 7630 may implement, for example, a standard protocol such as wireless access in vehicle environment (WAVE) which is a combination of IEEE802.11p of a lower layer and IEEE1609 of a higher layer, dedicated short range communications (DSRC), or a cellular communication protocol. The dedicated communication I/F 7630 typically performs V2X communication which is a concept including one or more of vehicle to vehicle communication, vehicle to infrastructure communication, vehicle to home communication, and vehicle to pedestrian communication.

The positioning unit 7640 receives, for example, a global navigation satellite system (GNSS) signal from a GNSS satellite (for example, a global positioning system (GPS) signal from a GPS satellite), executes positioning, and generates position information including a latitude, longitude, and altitude of the vehicle. Note that the positioning unit 7640 may specify a current position by exchanging signals with a wireless access point, or may acquire the position information from a terminal such as a mobile phone, a PHS, or a smartphone having a positioning function.

The beacon receiver 7650 receives, for example, radio waves or electromagnetic waves transmitted from a wireless station or the like installed on a road, and acquires information such as a current position, a traffic jam, a closed road, or a required time. Note that the functions of the beacon receiver 7650 may be included in the dedicated communication I/F 7630 described above.

The in-vehicle device I/F 7660 is a communication interface that mediates connection between the microcomputer 7610 and various in-vehicle devices 7760 existing in the vehicle. The in-vehicle device I/F 7660 may establish wireless connection by using a wireless communication protocol such as wireless LAN, Bluetooth (registered trademark), near field communication (NFC), or wireless USB (WUSB). In addition, the in-vehicle device I/F 7660 may establish wired connection such as universal serial bus (USB), high-definition multimedia interface (HDMI) (registered trademark), or mobile high-definition link (MHL) via a connection terminal (not shown) (and a cable, if necessary). The in-vehicle device 7760 may include, for example, at least one of a mobile device or a wearable device possessed by an occupant, or an information device carried in or attached to the vehicle. Furthermore, the in-vehicle device 7760 may include a navigation device that searches for a route to an arbitrary destination. The in-vehicle device I/F 7660 exchanges a control signal or a data signal with the in-vehicle devices 7760.

The in-vehicle network I/F 7680 is an interface that mediates communication between the microcomputer 7610 and the communication network 7010. The in-vehicle network I/F 7680 transmits and receives signals and the like in accordance with a predetermined protocol supported by the communication network 7010.

The microcomputer 7610 of the integrated control unit 7600 controls the vehicle control system 7000 in accordance with various programs on the basis of information acquired via at least one of the general-purpose communication I/F 7620, the dedicated communication I/F 7630, the positioning unit 7640, the beacon receiver 7650, the in-vehicle device I/F 7660, or the in-vehicle network I/F 7680. For example, the microcomputer 7610 may calculate a control target value for the driving force generating device, the steering mechanism, or the braking device on the basis of the acquired information about the inside or outside of the vehicle, and output a control command to the driving system control unit 7100. For example, the microcomputer 7610 may perform cooperative control intended to implement functions of an advanced driver assistance system (ADAS) which include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the acquired information about the outside or inside of the vehicle.

The microcomputer 7610 may generate three-dimensional distance information between the vehicle and an object such as a surrounding structure or a person on the basis of information acquired via at least one of the general-purpose communication I/F 7620, the dedicated communication I/F 7630, the positioning unit 7640, the beacon receiver 7650, the in-vehicle device I/F 7660, or the in-vehicle network I/F 7680, and create local map information including surrounding information of the current position of the vehicle. Furthermore, the microcomputer 7610 may predict danger such as collision of the vehicle, approach of a pedestrian or the like, or entry into a closed road on the basis of the acquired information, and generate a warning signal. The warning signal may be, for example, a signal for generating a warning sound or turning on a warning lamp.

The sound image output unit 7670 transmits an output signal of at least one of a sound or an image to an output device capable of visually or auditorily notifying an occupant of the vehicle or the outside of the vehicle of information. In the example of Fig. 21, an audio speaker 7710, a display unit 7720, and an instrument panel 7730 are exemplified as the output devices. The display unit 7720 may include at least one of an on-board display or a head-up display, for example. The display unit 7720 may have an augmented reality (AR) display function. The output device may be a device other than the above devices, such as a wearable device such as a headphone or an eyeglass-type display worn by an occupant, a projector, or a lamp. In a case where the output device is a display device, the display device visually displays results obtained by various processes performed by the microcomputer 7610 or information received from another control unit in various formats such as text, images, tables, and graphs. Furthermore, in a case where the output device is a sound output device, the sound output device converts an audio signal including reproduced sound data, acoustic data, or the like into an analog signal and aurally outputs the analog signal.

Note that, in the example illustrated in Fig. 21, at least two control units connected via the communication network 7010 may be integrated as one control unit. Alternatively, each control unit may include a plurality of control units. Furthermore, the vehicle control system 7000 may include another control unit (not shown). In addition, in the above description, some or all of the functions performed by any of the control units may be included in another control unit. That is, as long as information is transmitted and received via the communication network 7010, predetermined arithmetic processing may be performed by any control unit. Similarly, a sensor or a device connected to any of the control units may be connected to another control unit, and a plurality of control units may mutually transmit and receive detection information via the communication network 7010.

Note that the semiconductor laser driving apparatus 1 according to the present embodiment described with reference to Fig. 1 can be mounted on any of the control units or the like. Furthermore, it is also possible to provide the laser generator 110 and the LIDAR 100 on which such a semiconductor device is mounted.

In the vehicle control system 7000 described above, the semiconductor laser driving apparatus 1 according to the present embodiment described with reference to Fig. 1 can be applied to the outside-vehicle information detector 7420 of the application example illustrated in Fig. 21. For example, the light-emitting element controller 111 generates a signal for emitting a laser and outputs the signal to the LDD 20. The LDD 20 drives a VCSEL 10 by a signal from the light-emitting element controller 111 to emit laser light in a pulse form. A scanning mechanism 102 scans a target 103 existing in front of a vehicle with a laser light 102a.

The scanned laser light 102a hits the target 103, and then returns to the LIDAR 100 as the reflected light 103a. The reflected light 103a is received by the light-receiving element 105 via the condenser lens 104, converted from an optical signal into an electric signal, and input to the measurement circuit 106.

The measurement circuit 106 includes the ADC 106a, the TDC 106b, and the ranging algorithm, and by the ranging algorithm, measures a time difference between the laser light 102a and the reflected light 103a and measures a distance between the vehicle and the target 103.

Various data measured by the measurement circuit 106 is passed from the LIDAR 100 to an outside-vehicle information detection unit 7400 which is a configuration unit of a vehicle control system 7000. That is, the LIDAR 100 is the outside-vehicle information detector 7420 that detects the target 103 existing outside the vehicle and passes information regarding the target 103 to the outside-vehicle information detection unit 7400.

In the embodiments described above, it is possible to provide a semiconductor laser driving apparatus of a division emission scheme which reduces the wiring length between the LDD and the VCSEL and reduces a delay of a light emission pulse due to an influence of the wiring length of a light-emitting element of the VCSEL located far from the LDD, a LIDAR including the semiconductor laser driving apparatus, and a vehicle including the semiconductor laser driving apparatus.

The description of the above embodiments is an example of the present technology, and the present technology is not limited to the above embodiments. For this reason, it is a matter of course that various modifications can be made in accordance with a design and the like without departing from a technical idea of the present disclosure even in a case other than the above embodiments.

In addition, the effects herein described are merely examples and are not limited, and furthermore, other effects may be obtained. Furthermore, the configurations of the above embodiments can be combined in any manner. Therefore, the configuration examples herein described is merely an example, and is not limited to the configuration example of the present description.

Note that the present technology can have the following configurations.
(1) A semiconductor laser driving apparatus includes a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light.
(2) A semiconductor laser driving apparatus includes a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.
(3) In the semiconductor laser driving apparatus according to (2), each of the driving elements of the laser diode driver is disposed under the plurality of light-emitting elements included in the vertical cavity surface semiconductor laser, and is directly linked to each of the light-emitting elements to be drivable.
(4) In the semiconductor laser driving apparatus according to (1) or (2), the laser diode driver is configured to drive each of the light-emitting elements of the vertical cavity surface semiconductor laser by a charge charged in a capacitor connected to a power supply line in a chargeable manner.
(5) In the semiconductor laser driving apparatus according to (1) or (2), the vertical cavity surface semiconductor laser has a surface on which a micro lens array (MLA) is provided.
(6) In the semiconductor laser driving apparatus according to (1) or (2), the vertical cavity surface semiconductor laser has a connection electrode including an Au bump, a solder bump, or a Cu pillar bump.
(7) In the semiconductor laser driving apparatus according to (1) to (2), the laser diode driver has a circuit surface built in a substrate or a fan out wafer level package (FOWLP) in a state of facing toward a mounting surface of the vertical cavity surface semiconductor laser.
(8) In the semiconductor laser driving apparatus according to (7), a heat dissipation member is built in the substrate or the fan out wafer level package (FOWLP).
(9) In the semiconductor laser driving apparatus according to (7), the substrate or the fan out wafer level package (FOWLP) includes an external terminal of a land grid array (LGA) or a ball grid array (BGA) .
(10) A LIDAR includes a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light, or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.
(11) A vehicle includes a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light, or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.

### REFERENCE SIGNS LIST

- 1: Semiconductor laser driving apparatus
- 10: Vertical cavity surface emitting laser (VCSEL)
- 12: Substrate
- 13: Light-emitting element
- 14: Connection electrode
- 15: External terminal
- 16: Microlens array (MLA)
- 17: Semi-insulating substrate
- 18: Heat dissipation member
- 18a: Attachment hole
- 18b: Connection protrusion
- 19: Underfill
- 20: Laser diode driver (LDD)
- 21: Fan out wafer level package (FOWLP)
- 22: Connection via
- 23: Through mold via (TMV)
- 24: Metal layer
- 25: Metal layer
- 30: Capacitor
- 40: Motherboard
- 100: Light detection and ranging (LIDAR)
- 101: Microcontroller (MCU)
- 102: Scanning mechanism
- 102a: Laser light
- 103: Target
- 103a: Reflected light
- 104: Condenser lens
- 105: Light-receiving element
- 106: Measurement circuit
- 106a: Analog to digital converter (ADC)
- 106b: Time-to-digital converter (TDC)
- 110: Laser generator
- 7000: Vehicle control system
- 7400: Outside-vehicle information detection unit
- 7420: Outside-vehicle information detector
- T1 to T66: Driving element
- C1 to C66: Capacitance
- S1 to S66: Switch

## Claims

1. A semiconductor laser driving apparatus comprising: a vertical cavity surface semiconductor laser having a plurality of light-emitting elements; and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light.

2. A semiconductor laser driving apparatus comprising: a vertical cavity surface semiconductor laser having a plurality of light-emitting elements; and a laser diode driver disposed under the vertical cavity surface semiconductor laser and having a plurality of driving elements that is connected to the light-emitting elements from under the vertical cavity surface semiconductor laser and causes the light-emitting elements to emit light.

3. The semiconductor laser driving apparatus according to claim 2, wherein each of the driving elements of the laser diode driver is disposed under the plurality of light-emitting elements included in the vertical cavity surface semiconductor laser, and is directly linked to each of the light-emitting elements to be drivable.

4. The semiconductor laser driving apparatus according to claim 1, wherein the laser diode driver is configured to drive each of the light-emitting elements of the vertical cavity surface semiconductor laser by a charge charged in a capacitor connected to a power supply line in a chargeable manner.

5. The semiconductor laser driving apparatus according to claim 1, wherein the vertical cavity surface semiconductor laser has a surface on which a micro lens array (MLA) is provided.

6. The semiconductor laser driving apparatus according to claim 1, wherein the vertical cavity surface semiconductor laser has a connection electrode including an Au bump, a solder bump, or a Cu pillar bump.

7. The semiconductor laser driving apparatus according to claim 1, wherein the laser diode driver has a circuit surface built in a substrate or a fan out wafer level package (FOWLP) in a state of facing toward a mounting surface of the vertical cavity surface semiconductor laser.

8. The semiconductor laser driving apparatus according to claim 7, wherein a heat dissipation member is built in the substrate or the fan out wafer level package (FOWLP).

9. The semiconductor laser driving apparatus according to claim 7, wherein the substrate or the fan out wafer level package (FOWLP) includes an external terminal of a land grid array (LGA) or a ball grid array (BGA).

10. A LIDAR comprising: a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light; or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.

11. A vehicle comprising: a semiconductor laser driving apparatus including a vertical cavity surface semiconductor laser having a plurality of light-emitting elements, and at least two or more laser diode drivers disposed around the vertical cavity surface semiconductor laser and having a plurality of driving elements that is connected to the light-emitting elements from a peripheral surface of the vertical cavity surface semiconductor laser and causes the light-emitting elements to emit light; or a semiconductor laser driving apparatus including a vertical cavity surface semiconductor laser having a plurality of light-emitting elements, and a laser diode driver disposed under the vertical cavity surface semiconductor laser and having a plurality of driving elements that is connected to the light-emitting elements from under the vertical cavity surface semiconductor laser and causes the light-emitting elements to emit light.
